# EUROPEAN PATENT APPLICATION

(11) **EP 0 940 847 A2**
(43) Date of publication of application: **08.09.1999**
(21) Application number: 99301565.0
(22) Date of filing: 02.03.1999
(51) Int. Cl.: H01L 21/58, H01L 21/20, H01L 21/762, F24F 3/16, B01D 46/48

(54) **SOI substrate bonding under clean room conditions**

(30) Priority: 03.03.1998 JP 5065098
(71) Applicant: CANON KABUSHIKI KAISHA, Tokyo (JP)
(72) Inventor: Atoji, Tadashi, Ohta-ku, Tokyo (JP)
(74) Representative: Beresford, Keith Denis Lewis

(57) **Abstract**

A method of manufacturing a high-quality bonded SOI substrate is provided. The step of exposing the bonding interface between two substrates is performed in an atmosphere having cleanliness of Class 1 or more in Fed. St. 209D: USA IS standard. A clean room of Class 1 can be obtained using an air filter having a collection efficiency of 99.9999% (6N) or more for dust particles of a size of 0.1µm or more.

## Description

### BACKGROUND OF THE INVENTION

The present invention relates to an SOI substrate and a method and system for manufacturing the same and, more particularly, to an SOI substrate obtained by a manufacturing method comprising a step of bonding two substrates, and a method and system of manufacturing the same.

A substrate having a single-crystal silicon layer on an insulating layer is widely known as an SOI (Silicon On Insulator) substrate. A device using this SOI substrate has many advantages that cannot be achieved by ordinary bulk silicon substrates.

As one SOI technology, the SOS (Silicon On Sapphire) technology by which single-crystal silicon is heteroepitaxially grown on a sapphire substrate has been known for a long time. However, the single-crystal silicon layer obtained by heteroepitaxial growth has low crystal quality.

The SIMOX (Separation by Ion iMplanted OXygen) technology has appeared next to the SOS technology. The SIMOX technology has been put into practice as a technique of implanting an enormous number of oxygen ions into a silicon substrate and annealing the silicon substrate to form an oxide film buried at a depth of about 0.2 µm from the substrate surface. However, the SIMOX technology requires a long time for implantation of a number of oxygen ions and annealing. This is disadvantageous for productivity and cost. In addition, many crystal defects are generated in the SOI layer (single-crystal silicon layer) upon ion implantation. When the number of oxygen ions to be implanted is decreased, prescribed film quality of the oxide film can hardly be maintained by the conventional technology. It is also difficult to change the thickness of the buried oxide film.

As another SOI technology, the bonding SOI technology is known. In this technology, an insulating film is formed on at least one of two substrates by oxidation or the like, and the mirror surfaces of the two substrates are brought into tight contact with each other. This structure is annealed to increase the bonding strength of the contact interface. After this, one of the substrates is polished or etched from the lower surface to leave a single-crystal silicon thin film having an arbitrary thickness on the insulating film. One of the important processes of this technique is the process of leaving a single-crystal silicon thin film having an arbitrary thickness on the insulating film. More specifically, in this technique, normally, a silicon substrate as thick as several hundred µm must be uniformly polished or etched to a thickness of several or one µm or less. Such polishing or etching has a large technical difficulty from the viewpoint of controllability or uniformity.

Methods of forming a thin silicon film are roughly classified into two groups. One is the BPSOI (Bonding and Polishing SOI) method using only polishing, and the other is the BESOI (Bonding and Etchback SOI) method in which an etching stop layer is formed immediately on a thin film to be left (or immediately under the thin film when a single substrate is to be manufactured), and a silicon thin film is formed by two steps: etching of the substrate and etching of the etching stop layer.

In the BPSOI method, it is difficult to uniformly thin a silicon layer to 1 µm or less only by polishing. As an improvement over this method, a silicon layer is thinned to about 1 to 3 µm by polishing and then plasma-etched. Plasma etching is done by scanning a local plasma etching region while monitoring the film thickness distribution. Reportedly, a film thickness distribution of about ±10 nm can be obtained by this method.

Admittedly, the BESOI method is advantageous because the film thickness can be easily uniformed. This is because in the BESOI method, a silicon active layer is often epitaxially grown on an etching stop layer which has been formed in advance. For example, a thin p⁺-type Si thin layer containing boron at a high concentration and a p-type Si thin film are stacked on a p-type substrate by epitaxial growth to form a first substrate. The first substrate is bonded to a second substrate while sandwiching an insulating layer such as an oxide film. The first substrate is thinned from the lower surface by grinding or polishing. Then, the remaining p-type Si thin film is selectively etched to expose the p⁺-type Si thin layer. In addition, the p⁺-type Si thin film is selectively etched to expose the p-type Si thin film, thereby completing an SOI structure. This method is described in detail in the report by Maszara et al (W.P. Maszara, J. Electrochem. Soc., vol. 138, 341, 1991).

A method of obtaining a bonding interface with high planarity and an active layer having a uniform thickness while improving the etchback selectivity by several orders of magnitudes as compared to that in the BESOI method is disclosed in Japanese Patent Laid-Open No. 5-21338. In the method disclosed in Japanese Patent Laid-Open No. 5-21338, the surface of a silicon substrate is anodized to form a porous layer, a silicon active layer is formed on the porous layer by epitaxial growth to prepare a first substrate, and the first substrate is bonded to a second substrate. In this case, the porous silicon layer on the first substrate corresponds to the etching stop layer in the BESOI method. Since an etchant based on hydrofluoric acid has a much higher etching rate for porous silicon than that for single-crystal silicon, a high selectivity ratio can be realized.

In the method disclosed in Japanese Patent Laid-Open No. 5-21338, a porous silicon layer is formed by anodizing the surface of a flat single-crystal silicon substrate. For this reason, the planarity of an active layer formed by epitaxial growth is higher than that in the BESOI method in which an etching stop layer is formed by CVD or the like. Additionally, an epitaxial layer having almost the same crystallinity as that of an epitaxial layer formed on a non-porous single-crystal silicon substrate can be formed on the porous silicon layer. Hence, according to this method, an SOI substrate having satisfactory crystallinity and excellent film thickness uniformity can be formed.

In the report by K. Sakaguchi et al., the surface of a single-crystal silicon substrate was anodized to form a porous layer, and an epitaxial layer was grown on the porous layer to prepare a first substrate. The first substrate was bonded to a second silicon substrate having an oxidized surface. The non-porous single-crystal silicon portion was ground from the lower surface side of the first substrate using a grinder to expose the porous layer. When only the porous layer was selectively etched using a mixed solution of HF/H₂O₂, an SOI layer (single-crystal silicon layer) having a film thickness distribution of 507 nm ± 15 nm (±3%) or 96.8 nm ± 4.5 nm (±4.7%) on a 5-inch wafer was obtained. Also, they reported that in etching using the mixed solution of HF/H₂O₂, the etching rate for a porous silicon layer was 10⁵ times that for a non-porous silicon layer.

As the second substrate, not only a single-crystal silicon substrate having a thermally oxidized surface but also a transparent silica substrate can be used.

Alternatively, a thermal oxide film is formed on the surface of an epitaxial layer formed on a porous silicon substrate to prepare a first substrate, which is bonded to a second substrate having no oxide film. Furthermore, oxide films may be formed on both the first and second substrates to be bonded.

The interface level of the interface between the epitaxial layer as an active layer and the oxide film (thermal oxide film on the epitaxial layer) is sufficiently low, and the thickness of the oxide film can be arbitrarily controlled. For this reason, a substrate capable of sufficiently exhibiting the characteristics of an SOI structure can be manufactured by the above method.

As described above, the bonding SOI technology is more promising than the SIMOX technology although the process of bonding two substrates has a problem.

In the bonding process, if a foreign substance or impurity is present on the bonding interface between two substrates, a gap called a "void" is formed in the bonding interface. When a void is formed, a small hole may be formed in the SOI layer corresponding to the void by the foreign substance in the process of thin film formation by grinding, polishing, or etching after bonding the two substrates, or the SOI layer may partially change in its properties by the foreign substance or impurity. This void portion may break and fall off.

When an etchant based on hydrohydrofluoric acid is used for thin film formation, the etchant may enter the SOI layer through a small hole formed by a foreign substance to largely etch the oxide film at the bonding interface. In this case, the upper SOI layer breaks and falls off. Alternatively, that portion of the SOI layer, which has changed in its properties, may be etched by an etchant based on hydrohydrofluoric acid used for thin film formation. In this case as well, the etchant enters the SOI layer through the hole, resulting in the same situation as described above.

Such defects often appear when the resultant SOI substrate is etched using concentrated hydrohydrofluoric acid, and are called, e.g., HF voids, HF pits, or HF defects. These defects are reported in detail by D.K. Sadana et al (D.K. Sadana et al; Proceeding 1994 IEEE International SOI Conference, Oct. 1994). According to this report, HF voids are present even in a SIMOX substrate. Consequently, a portion contaminated by a metal impurity upon implanting oxygen ions into a silicon substrate forms a portion that has changed in its properties in an SOI layer, and when this portion that has changed in its properties is etched with HF, a hole is formed.

In the process of manufacturing a silicon semiconductor device, an etchant based on hydrohydrofluoric acid is normally used for substrate cleaning or etching of an oxide film. When an SOI layer breaks and falls off during this process, particles are generated, and additionally, a device having an active layer at the missing portion from which the SOI layer has fallen off does not operate at all. As the degree of integration of a semiconductor device using an SOI substrate increases, the probability that an active region has a missing portion increases, resulting in a decrease in yield of semiconductor devices.

Even when foreign substances or impurities present at the bonding interface have not formed any voids, they may diffuse into an oxide film or silicon upon annealing after bonding.

A metal impurity or oxide-based impurity may also form HF voids.

Additionally, a small amount of chemical impurity such as boron coming from an external atmosphere or generated from human bodies, wall material, or floor covering material and floating in the air diffuses into the SOI active layer to impede manufacturing a device. On the interface of silicon/oxide film bonded in a normal clean room, boron is observed at about 10¹⁹ atoms/cm³. Diffusion of such a chemical impurity poses a serious problem in forming a high-quality SOI active layer. For a bonded SOI substrate, no clear product specifications about HF voids or impurity are defined. However, an HF void or impurity actually influences the non-defective yield of bonded SOI substrate and is reflected on the manufacturing cost.

As described above, it is very important for the manufacture of a bonded SOI substrate to prevent a foreign substance or impurity from sticking to the bonding interface.

### SUMMARY OF THE INVENTION

The present invention has been made in consideration of the above situation, and has as its object to provide a method of manufacturing a high-quality bonded SOI substrate.

It is another object of the present invention to improve the yield and reduce the manufacturing cost.

According to an aspect of the present invention, there is provided an SOI substrate manufacturing method comprising the step of bonding two substrates, characterized in that at least the step of exposing a bonding interface between the two substrates to be bonded is performed in an atmosphere having cleanliness of not less than Class 1 in Fed. St. 209D: USA IS standard.

In the SOI substrate manufacturing method, the atmosphere having cleanliness of not less than Class 1 can be obtained using, e.g., an air filter having a collection efficiency of not less than 99.9999% for dust particles of a size of not less than 0.1-µm.

In the SOI substrate manufacturing method, the atmosphere having cleanliness of not less than Class 1 can be obtained using, e.g., an air filter having a collection efficiency of not less than 99.99999% for dust particles of a size of not less than 0.1-µm. This air filter preferably comprises an air filter having a PTFE (polytetrafluoroethylene) filter medium.

According to another aspect of the present invention, there is provided an SOI substrate manufacturing method comprising the step of bonding two substrates, characterized in that at least the step of exposing a bonding interface between the two substrates to be bonded is performed in clean air filtered by an air filter having a PTFE (polytetrafluoroethylene) filter medium.

In the SOI substrate manufacturing method, at least the step of exposing a bonding interface between the two substrates to be bonded is preferably performed in clean air filtered not only by the air filter but also by a chemical filter.

In the SOI substrate manufacturing method, the step of exposing a bonding interface between the two substrates to be bonded is preferably performed in a clean air downflow through the air filter.

In the SOI substrate manufacturing method, the air filter is preferably arranged, on an entire ceiling surface of a clean room, at least above an apparatus for performing the step of exposing the bonding interface between the two substrates to be bonded.

In the SOI substrate manufacturing method, the air filter is preferably arranged not only on the ceiling of the clean room but also in an apparatus for processing the substrates with the exposed bonding interface.

In the SOI substrate manufacturing method, charge buildup in substances is preferably prevented at least in an area where the step of exposing the bonding interface between the two substrates to be bonded is performed.

In the SOI substrate manufacturing method, a gas pipeline coupled to an apparatus for forming or processing a bonding interface preferably wholly or partially comprises a CRP pipe.

In the SOI substrate manufacturing method, preferably, at least the step of exposing a bonding interface between the two substrates to be bonded is performed in an environment where cleanliness is ensured by a local clean room system, and the air filter is arranged in each of apparatuses for performing the step of exposing the bonding interface in the local clean room system and a conveyance apparatus between the apparatuses.

In the SOI substrate manufacturing method, an automatic apparatus which requires no manual operation in bonding is preferably used as an apparatus for bonding the two substrates.

According to still another aspect of the present invention, there is provided an SOI substrate manufacturing method comprising the step of bonding two substrates, characterized in that an SOI substrate is manufactured in an environment where dust which may stick to a bonding interface between the two substrates is eliminated to obtain a void density of not more than 0.5 pieces/cm² after the manufactured SOI substrate is dipped in a 49% concentrated HF solution for 15 min.

According to still another aspect of the present invention, there is provided an SOI substrate manufacturing method comprising the step of bonding two substrates, characterized in that an SOI substrate is manufactured in an environment where chemical impurities which may contaminate a bonding interface between the two substrates is eliminated to obtain a boron concentration of not more than 1 × 10¹⁶ atoms/cm³ on the bonding interface of the manufactured SOI substrate.

Each of the above SOI substrate manufacturing methods can be applied to a manufacturing process comprising the steps of forming a porous layer on a substrate and forming a non-porous layer containing a single-crystal layer on the porous layer to prepare a first substrate, bonding the first substrate to an independently prepared second substrate while sandwiching the non-porous layer therebetween, removing the first substrate side from a bonded substrate stack to leave the porous layer on a surface on the second substrate side, and etching the porous layer left on the surface on the second substrate side.

Each of the above SOI substrate manufacturing methods can be applied to a manufacturing process comprising the steps of implanting ions into a first substrate to form a micro-cavity layer, bonding the first substrate having the micro-cavity layer to an independently prepared second substrate, separating a bonded substrate stack at the micro-cavity layer, and removing the micro-cavity layer left on a surface on the first substrate side.

Each of the above SOI substrate manufacturing methods can be applied to a manufacturing process comprising the steps of forming an oxide film on a first substrate, bonding the first substrate having the oxide film to an independently prepared second substrate while sandwiching the oxide film therebetween, and grinding the first substrate side of a bonded substrate stack and thinning the bonded substrate stack.

According to still another aspect of the present invention, there is provided an SOI substrate manufactured by a manufacturing method comprising the step of bonding two substrates, characterized in that a void density obtained when the SOI substrate is dipped in a 49% concentrated HF solution for 15 min is not more than 0.5 pieces/cm².

According to still another aspect of the present invention, there is provided an SOI substrate manufactured by a manufacturing method comprising the step of bonding two substrates, characterized in that an average void density obtained when the SOI substrates are dipped in a 49% concentrated HF solution for 15 min is not more than 0.5 pieces/cm².

According to still another aspect of the present invention, there is provided an SOI substrate manufactured by a manufacturing method comprising the step of bonding two substrates, characterized in that a concentration of boron on a bonding interface is not more than 1 × 10¹⁶ atoms/cm³.

According to still another aspect of the present invention, there is provided an SOI substrate manufactured by a manufacturing method comprising the step of bonding two substrates, characterized in that an average concentration of boron on a bonding interface is not more than 1 × 10¹⁶ atoms/cm³.

A manufacturing system according to the present invention is suitable to the above manufacturing methods.

Further objects, features and advantages of the present invention will become apparent from the following detailed description of embodiments of the present invention with reference to the accompanying drawings.

### BRIEF DESCRIPTION OF THE DRAWINGS

Fig. 1 is a sectional view showing the schematic arrangement of a clean room of Example 1 of the first embodiment;
Fig. 2 is a sectional view showing the schematic arrangement of a clean room of Example 2 of the first embodiment;
Fig. 3 is a plan view showing the schematic arrangement of a clean room for manufacturing a bonded SOI substrate by ELTRAN;
Figs. 4A to 4F are views showing the steps of manufacturing a bonded SOI substrate by ELTRAN;
Figs. 5A to 5E are views showing the steps of manufacturing a bonded SOI substrate by ion implantation peeling;
Fig. 6 is a sectional view showing the schematic arrangement of a clean room of Example 1 of the second embodiment;
Fig. 7 is a sectional view showing the schematic arrangement of a clean room of Example 2 of the second embodiment; and
Fig. 8 is a plan view showing the schematic arrangement of a clean room for manufacturing a bonded SOI substrate by ELTRAN.

### DETAILED DESCRIPTION OF THE PREFERRED EMBODIMENTS

In an SOI substrate manufacturing method according to preferred embodiments of the present invention, a bonded SOI substrate is manufactured under an environment in which 39 or less dust particles each having a size of 0.1-µm or more are present per cubic foot. With this arrangement, a change in properties of an SOI layer or the like due to a chemical such as hydrofluoric acid used in substrate cleaning or etching is decreased.

### [First Embodiment]

In this embodiment, a method of manufacturing a bonded substrate stack without exposing the bonding interface between substrates to be bonded to any atmospheres other than clean air having cleanliness of Class 1 or more in Fed. St. 209D: USA IS standard is disclosed. According to this manufacturing method, foreign substances such as dust can be prevented from adhering to the bonding interface, and a change in properties of an SOI layer or the like due to a chemical such as hydrofluoric acid used in substrate cleaning or etching can be decreased.

In a manufacturing system according to this embodiment, an air filter (to also be referred to as a 6N air filter hereinafter) having a collection efficiency of 99.9999% (6N) or more for dust particles of a size of 0.1µm or more is set on the upstream of a vertical downflow with a controlled airflow velocity, thereby constructing a clean room in which 39 or less dust particles each having a size of 0.1-µm or more are present per cubic foot. The 6N air filter can be formed from, e.g., a glass filter medium or a low-pressure-loss-type PTFE (polytetrafluoroethylene) filter medium.

The manufacturing system of this embodiment also takes charge buildup in the clean room into consideration. In cleaning of silicon wafers and, more particularly, in drying after cleaning, rotary drying is performed while spraying an enormous amount of air to the wafers. At this time, static electricity of several thousand V or more is generated due to friction between the large quantity of air and wafers to attract dust. In the clean room, antistatic fixtures are used. However, many wafer carriers or conveyor boxes made of Teflon, which are used to store or convey wafers, or rubber or vinyl gloves having insulating properties are still used without any antistatic treatment. Charge builds up in these fixtures by friction and attracts light dust in the ambient.

In the manufacturing system of this embodiment, a mechanism for minimizing charge buildup in any substances in the clean room is arranged to prevent dust from sticking to any substances. Especially, in the manufacturing system of this embodiment, sticking of dust particles/foreign substances to the bonding interface is minimized.

The manufacturing method of the present invention can be implemented even in a conventional clean room with cleanliness of Class 100 to 1000 by employing a local clean room system such as SMIF (Standard Mechanical InterFace).

The local clean room system such as SMIF uses an inter-apparatus conveyance local clean box system having an outer clean room, a wafer loading mechanism for loading wafers into an isolated apparatus, and a wafer recovering mechanism. According to this system, substrates being manufactured are not exposed to the outer clean room atmosphere of Class 100 to 1000.

When a bonded SOI substrate manufactured by the method of this preferred embodiment of the present invention is immersed in a 49% concentrated HF solution for 15 min, the HF void density is 0.5 pieces/cm² or less.

The HF void density of 0.5 pieces/cm² or less corresponds to cleanliness of Class 1 or more in Fed. St. 209D: USA IS standard with which 39 or less dust particles each having a size of 0.1-µm or more are present per cubic foot, i.e., 0.00137 or less dust particles each having a size of 0.1-µm or more are present per cubic centimeter.

Assume that dust particles are uniformly distributed, and a wafer is left to stand in a vertical downflow with a normal airflow velocity of 40 cm/s. In this case, 0.55 dust particles pass through the wafer per unit area in 10 sec. More specifically, in the clean room of Class 1 in the USA IS standard, when a wafer is left to stand perpendicular to the vertical downflow with an airflow velocity of 40 cm/s for 10 sec, 0.55/cm² dust particles may be sprayed to the wafer.

In the manufacturing system of this embodiment, wafers parallel to the floor surface, i.e., perpendicular to the vertical downflow are extracted from a wafer carrier and bonded on a stage. The time required to extract the wafers from the wafer carrier and bond them is 10 sec or less. Assuming that all dust particles sprayed to the substrates during this time form HF voids, the HF void density upon bonding the wafers in the clean room of Class 1 in the USA IS standard within 10 sec is probably 0.5 pieces/cm².

Specific examples of this embodiment will be described below.

### (Example 1)

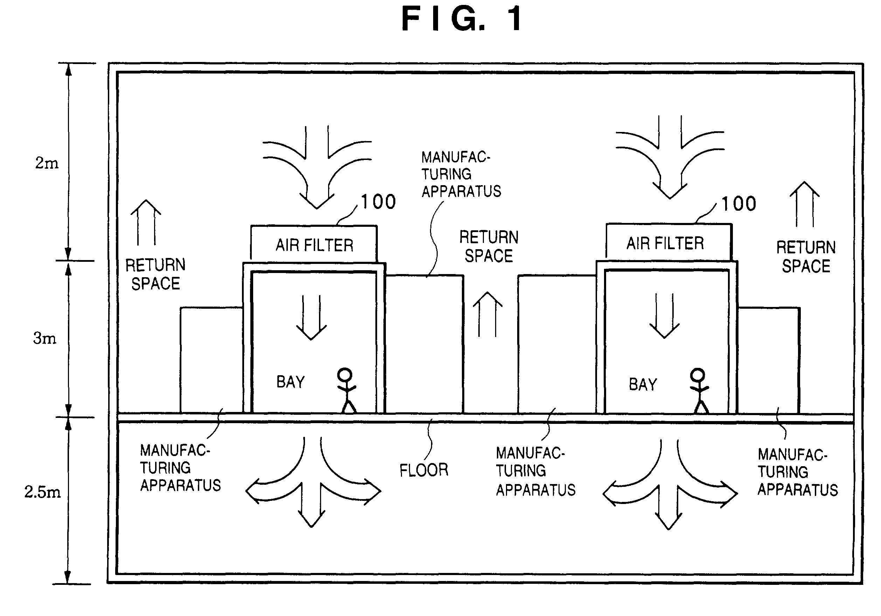

Fig. 1 is a sectional view showing the schematic arrangement of a clean room of Example 1 of the first embodiment. The clean room of Example 1 has various apparatuses for manufacturing a bonded SOI substrate.

In Example 1, as shown in Fig. 1, a clean room with cleanliness of Class 1 or more in Fed. St. 209D: USA IS standard is constructed using an air filter (6N air filter) having a collection efficiency of 99.9999% (6N) or more for dust particles of a size of 0.1µm or more in a downflow bay system.

More specifically, this clean room has an underfloor space of 2.5 m, a floor space of 3.0 m, and a ceiling space of 2.0 m. In this clean room, the underfloor space and floor space are partitioned by floor with a mesh structure (grating floor) through which air can pass. In the bay area, a 6N air filter 100 is set in the ceiling. Clean air passing through the 6N air filter 100 is sent from the ceiling to the floor and then to the underfloor through the floor as a vertical downflow with an airflow velocity of 0.3 to 0.45 m/s.

The air sent to the underfloor returns to the ceiling through the return space next to the bay area and circulates again through the 6N air filter 100. The return space and bay area are completely partitioned by a wall or through the wall structure on the floor. The air filter in each manufacturing apparatus is also a 6N air filter. Hence, substrates being manufactured are exposed to only clean air passing through the 6N air filter.

In the clean room with the above arrangement, 39 or less dust particles each having a size of 0.1-µm or more are present per cubic foot (0.00137 or less dust particles each having a size of 0.1-µm or more are present per cubic centimeter), so cleanliness of Class 1 or more in Fed. St. 209D: USA IS standard is realized. At each of 29 measurement points in the bay area, 1 cubic foot or more of air was sampled, and the particle density in the air was measured three times using a dust counter capable of measuring 0.1-µm or more particles. The particle density was 0 particle/cubic foot at all points.

Table 1 shows the HF void densities obtained when bonded SOI substrate manufactured in the clean room of Class 1 shown in Fig. 1 and a bonded SOI substrate manufactured in a clean room of Class 100 (Comparative Example 1) were etched using concentrated hydrofluoric acid (49%) for 15 min. Both bonded SOI substrates had an SOI film thickness of 200 nm and a buried oxide film thickness of 200 nm.

**Table 1**

| | Clean room | HF void density |
|---|---|---|
| Example | Class 1 | 0.22 pieces/cm² on average |
| Comparative Example 1 | Class 100 | 0.89 pieces/cm² on average |

As shown in Table 1, when the clean room of Class 1 using an air filter having a collection efficiency of 99.9999% (6N) or more for dust particles of a size of 0.1µm or more was constructed in the downflow bay system, the particles/foreign substances on the bonding interface could be decreased, and the HF void density could be largely lowered.

Example 1 is associated with a clean room in a bay system in which bays and return spaces alternate. However, the same effect as described above can be expected even when, in a clean room with a double structure, an air filter is set on the entire ceiling surface of the inner room, and the outer room is used as a return space.

### (Example 2)

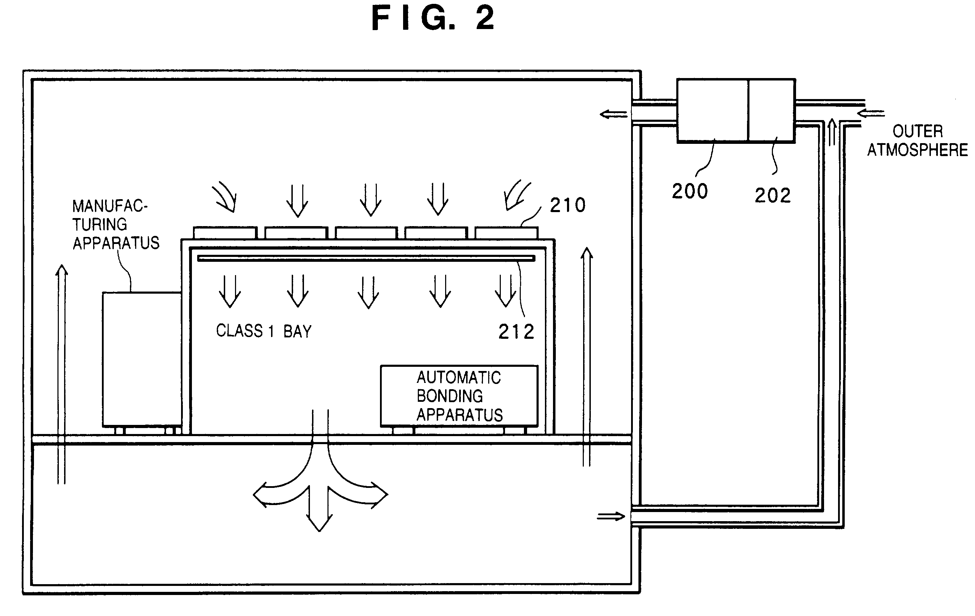

Fig. 2 is a sectional view showing the schematic arrangement of a clean room of Example 2 of the first embodiment. The clean room of Example 2 has not only apparatuses shown in Fig. 2 but also various apparatuses for manufacturing a bonded SOI substrate.

In Example 2, in the bay area of Class 1, i.e., in an area where substrates being manufactured are exposed, an ionizer 212 for preventing charge buildup in various substances in the clean room is mounted on the ceiling, as shown in Fig. 2. With the neutralization effect by the ionizer 212, particles can be prevented from sticking to wafers, wafer carriers, and the like.

In respect of charge buildup in the clean room, cleaning silicon wafers and, more particularly, drying after cleaning must be done with caution. In drying, rotary drying is performed while spraying an enormous amount of air to the wafers. At this time, static electricity of several thousand V or more is generated due to friction between the large quantity of air and wafers to attract dust. In the clean room, antistatic fixtures are used. However, many wafer carriers or conveyor boxes made of Teflon, which are used to store or convey wafers, or rubber or vinyl gloves having insulating properties are still used without any antistatic treatment. Charge builds up in these fixtures by friction and attracts light dust in the ambient.

The ionizer generates charges necessary for neutralization, i.e., charges having a polarity opposite to that of charged substances and supplies the charges to the charged substances for neutralization. The charges with opposite polarity are generated by ionizing gas molecules with an electric energy such as an electric field to generate ion pairs.

In Table 2, the HF void densities obtained when a bonded SOI substrate manufactured in the clean room of Class 1 shown in Fig. 2 and a bonded SOI substrate manufactured in a conventional clean room of Class 100 (Comparative Example 1) were etched using concentrated hydrofluoric acid (49%) for 15 min are compared. Both bonded SOI substrates had an SOI film thickness of 200 nm and a buried oxide film thickness of 200 nm.

**Table 2**

| | Clean room | Ionizer | HF void density |
|---|---|---|---|
| Example | Class 1 | Present | 0.09 pieces/cm² on average |
| Comparative Example 1 | Class 100 | Absent | 0.89 pieces/cm² on average |

As shown in Table 2, when the clean room of Class 1 using an air filter having a collection efficiency of 99.9999% (6N) or more for dust particles of a size of 0.1µm or more was constructed in the downflow bay system, and the ionizer was set on the ceiling to prevent charge buildup in various substances such as wafers and wafer carriers in the clean room, any particles/foreign substances on the bonding interface could be decreased, and the HF void density could be largely lowered.

In Example 2, DC MODEL442 available from Hugle Electronics was employed as the ionizer 212 and set under a 6N air filter 210. As an ionizer to be set in an air shower or a compact ionizer to be locally set, an equivalent product available from another company and having a similar neutralization effect may be combined.

Example 2 is associated with a clean room in a bay system in which bays and return spaces alternate. However, the same effect as described above can be expected even when, in a clean room with a double structure, an air filter is set on the entire ceiling surface of the inner room, the outer room is used as a return space, by partitioning at least an area for forming a bonding interface, i.e., an area from cleaning two substrates to be bonded to bonding by a wall or the like and using a 6N air filter.

Referring to Fig. 2, reference numeral 200 denotes an air conditioner; and 202, an air filter.

### (Example 3)

In Example 3, in a clean room of Class 100, an SMIF system having a 6N air filter in a manufacturing apparatus is employed, and an SMIF system having a 6N air filter is employed to convey wafers in an apparatus and between apparatuses for forming a bonding interface and bonding wafers.

The SMIF system has not only a semiconductor manufacturing apparatus with an SMIF pod and an SMIF enclosure but also robots such as an SMIF arm and an SMIF loader.

The SMIF pod is a case/container with a good seal used to convey or store wafer carrier and contains a clean inert gas or the like. A wafer carrier in the SMIF pod is inserted/extracted to/from the semiconductor manufacturing apparatus in the SMIF enclosure of a local clean room having a 6N air filter by a wafer carrier loading mechanism and dedicated robots such as an SMIF arm and SMIF loader having a recovery mechanism. The outer clean room and wafers, or human bodies and wafers are completely isolated from each other.

An apparatus for performing a process after bonding interface formation and until bonding, and an SMIF enclosure between apparatus also preferably has a 6N air filter.

Even when the local clean room system such as the SMIF system is employed, the same effect as in Examples 1 and 2 can be obtained by setting wafers in the same environment as in Examples 1 and 2.

### (Example 4)

Example 4 is associated with ELTRAN as a method of manufacturing a bonded SOI substrate. In ELTRAN, the front surface side of a first substrate having a porous layer on this surface and a non-porous layer containing a single-crystal layer on the porous layer is bonded to an independently prepared second substrate. After this, the first substrate side is removed, and the porous layer remaining on the surface on the second substrate side is selectively removed, thereby transferring the single-crystal layer on the first substrate to the second substrate.

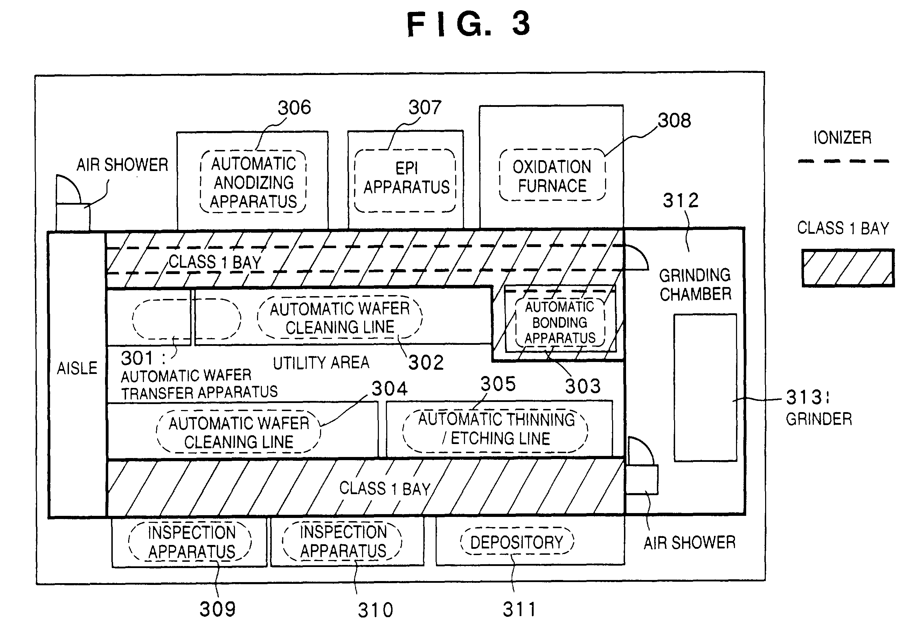

Fig. 3 is a plan view showing the schematic arrangement of a clean room for manufacturing a bonded SOI substrate by ELTRAN.

The clean room shown in Fig. 3 is a clean room of the bay system. Referring to Fig. 3, the area of "Class 1 bay" is an area where a 6N air filter is set on the entire ceiling surface, and a vertical downflow of clean air having a controlled airflow velocity of about 0.3 to 0.45 m/s is formed.

More specifically, this clean room has an underfloor space of 2.5 m, a floor space of 3.0 m, and a ceiling space of 2.0 m. In this clean room, the underfloor space and floor space are partitioned by floor with a mesh structure (grating floor) through which air can pass. In the bay area, a 6N air filter is set in the ceiling. Clean air passing through the 6N air filter is sent from the ceiling to the floor and then to the underfloor through the floor as a vertical downflow with an airflow velocity of 0.3 to 0.45 m/s. The air sent to the underfloor returns to the ceiling through the return space (utility area) next to the bay area and circulates again through the 6N air filter. The return space and bay area are completely partitioned by a wall or through the wall structure on the floor.

The filter in each of manufacturing apparatuses 301 to 308 is also a 6N air filter. Hence, substrates being manufactured are exposed to only clean air passing through the 6N air filter.

In the clean room of Example 4, 39 or less dust particles each having a size of 0.1-µm or more are present per cubic foot (0.00137 or less dust particles each having a size of 0.1-µm or more are present per cubic centimeter), so cleanliness of Class 1 or more in Fed. St. 209D: USA IS standard is realized. At each of 29 measurement points in the bay area, 1 cubic foot or more of air was sampled, and the particle density in the air was measured three times using a dust counter capable of measuring 0.1-µm or more particles. The particle density was 0 particle/cubic foot at all points. In the manufacturing apparatuses 301 to 308 as well, cleanliness of Class 1 or more in Fed. St. 209D: USA IS standard is realized.

In Example 4, an ionizer is set on the ceiling of the Class 1 bay in which the automatic anodizing apparatus 306, the epitaxial growth apparatus (Epi apparatus) 307, the oxidation furnace 308, the automatic wafer transfer apparatus 301, the automatic wafer cleaning line 302, and the automatic bonding apparatus 303 are located on both sides. The ionizer neutralizes wafers or wafer carriers in which charge has built up upon loading/unloading wafers.

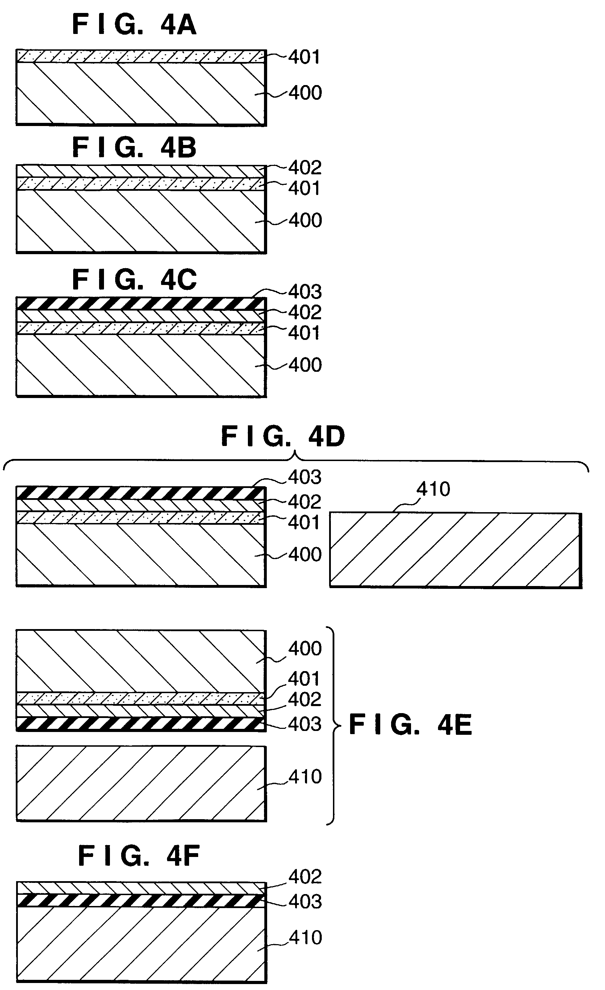

Steps of manufacturing a bonded SOI substrate by ELTRAN in the clean room shown in Fig. 3 will be described below. Figs. 4A to 4F are views showing steps of manufacturing a bonded SOI substrate by ELTRAN.

In the step shown in Fig. 4A, a single-crystal silicon substrate 400 is anodized by the automatic anodizing apparatus 306 to form a porous silicon layer 401. At this time, the thickness of the porous layer on the single-crystal silicon substrate 400 is preferably, e.g., several µm to several ten µm. However, the substrate may be wholly anodized.

To form a porous silicon layer, a p-type single-crystal silicon substrate 400 is preferably prepared. An n-type single-crystal silicon substrate may be used. In this case, however, a substrate having a low resistance must be prepared, or generation of holes must be prompted in anodizing by irradiating the substrate surface with light.

In Example 4, the p-type single-crystal silicon substrate 400 was cleaned by the automatic wafer cleaning line 302, and then, one surface of the p-type single-crystal silicon substrate 400 was anodized by the automatic anodizing apparatus 306 by about 10 µm to form a porous silicon layer 401.

In the step shown in Fig. 4B, a non-porous single-crystal silicon layer 402 is epitaxially grown on the porous silicon layer 401. Epitaxial growth can be performed by general thermal CVD, low-pressure CVD, plasma CVD, molecular beam epitaxial growth, or sputtering. In Example 4, the pore wall portions in the porous silicon layer 401 were slightly surface-oxidized by the oxidation furnace 308, and then, the single-crystal silicon layer 402 was formed by the epitaxial growth apparatus (Epi apparatus) 307 next to the oxidation furnace 308. The thickness of the epitaxially grown layer is designed in consideration of the SOI active layer, the amount be consumed by the buried oxide film, and the amount to be decreased upon cleaning.

In the step shown in Fig. 4C, the surface of the single-crystal silicon layer (epitaxial layer) 402 is oxidized by the oxidation furnace 308 to form a buried oxide film 403 having a predetermined thickness.

In the step shown in Fig. 4D, the substrate 400, i.e., a first substrate on which the porous silicon layer 401, single-crystal silicon layer 402, and oxide film 403 are formed, and a silicon substrate 410 as a second substrate are prepared. As the support substrate 410, not only a substrate having an oxidized surface, a silica glass substrate, or a crystallized glass substrate but also a substrate prepared by forming an oxide film on an arbitrary substrate can be selected. In Example 4, as the support substrate, a silicon substrate whose surface was not oxidized was selected, and the substrate 400 on which the porous silicon layer 401, single-crystal silicon layer 402, and oxide film 403 were formed and the silicon substrate (support substrate) 410 were cleaned by the automatic wafer cleaning line 302.

One or both of the first and second substrates may be exposed to a plasma atmosphere to activate the surface oxide film and improve the bonding strength. As a gas, oxygen is preferably used. Alternatively, a gas such as air (mixed gas of oxygen and nitrogen), nitrogen, or hydrogen, an inert gas such as argon or helium, or a molecular gas such as ammonia may be used.

In the step shown in Fig. 4E, the cleaned substrates are conveyed from the automatic wafer cleaning line 302 to the automatic bonding apparatus 303 and bonded by the automatic bonding apparatus 303. In the clean room of Example 4, a number of ionizers are set on the ceiling of an area from the unloader portion of the automatic wafer cleaning line 302 to the automatic bonding apparatus 303 to neutralize wafers or wafer carriers in which charge has built up upon loading/unloading wafers.

Subsequently, the bonded substrate stack is annealed to increase the bonding strength. Annealing temperature is preferably high to some extent. However, if the temperature is excessively high, the structure of the porous silicon layer 401 may change, or an impurity contained in the substrate may diffuse into the single-crystal silicon layer (epitaxial layer) 402. For this reason, a temperature and time which do not pose such a problem must be selected. More specifically, a temperature of 1,200°C or less is preferable.

Some substrates cannot be treated at high temperatures. For example, when the support substrate 410 is a silica glass substrate, this substrate must be annealed at a temperature of about 200°C or less because of the difference in thermal expansion coefficient between silicon and silica glass. At higher temperatures, the bonded substrate stack may peel or break by stress. However, a bonding interface which can withstand stress in the next grinding or etching process of the bulk silicon 400 need only be obtained by annealing. Hence, when the surface treatment conditions in activation are optimized, annealing temperature can be set at 200°C or less.

In the step shown in Fig. 4F, the non-porous single-crystal silicon portion 400 and porous silicon layer 401 are selectively removed to leave the single-crystal silicon layer (epitaxial layer) 402. With this process, an SOI substrate having a satisfactory film thickness distribution is completed.

In this process, the non-porous single-crystal silicon portion 400 is ground by a grinder 313 or the like in a grinding chamber 312 by about several hundred µm, and then dry-etched by about several µm by RIE (Reactive Ion Etching) to expose the porous layer 402. The entire non-porous single-crystal silicon portion 400 may be removed only by grinding using a grinder or the like or only by RIE dry etching to expose the porous silicon layer 402.

The single-crystal silicon portion 400 is ground in the grinding chamber 312 partitioned by a wall. In Example 4, cleanliness of the grinding chamber 312 is roughly Class 100.

The porous silicon layer 402 is exposed and then selectively etched by an automatic thinning/etching line 305 to leave the single-crystal silicon layer (epitaxial layer) 402. The etching rate for porous silicon is 10⁵ to 10⁶ times that for non-porous silicon. For this reason, when a number of wafers are subjected to a batch process in units of wafer carriers in the automatic thinning/etching line 305, SOI substrates having a satisfactory film thickness distribution can be obtained.

Etching of porous silicon progresses rapidly when the pore walls abruptly break by the etching function of an etchant entering the pores. Hence, the etching selectivity ratio of porous silicon to non-porous silicon reaches 10⁵ to 10⁶ times. The underlying single-crystal silicon layer (epitaxial layer) 402 is formed from non-porous silicon and therefore etched little because the etching rate is smaller than that for porous silicon by five to six orders of magnitudes. The single-crystal silicon layer 402 is left as a uniform SOI thin film maintaining the film thickness uniformity upon epitaxial growth.

With the above process, an SOI substrate having a satisfactory film thickness distribution is completed. In Example 4, the SOI substrate is cleaned by the automatic wafer cleaning line 304, and then, hydrogen annealing is performed to planarize the surface.

To prevent boron contaminating the anodized p-type single-crystal silicon substrate 400 from diffusing into the SOI active layer, hydrogen annealing is performed to externally diffuse boron.

A bonded SOI substrate manufactured in the clean room of Example 4 and a bonded SOI substrate manufactured in a clean room of Class 100 (Comparative Example 3) were etched using concentrated hydrofluoric acid (49%) for 15 min. Table 3 shows the HF void densities at this time and boron concentrations in the SOI active layers obtained by SIMS analysis. Both bonded SOI substrates had an SOI film thickness of 200 nm and a buried oxide film thickness of 200 nm.

**Table 3**

| | Clean room | HF void density |
|---|---|---|
| Example | Class 1 | 0.03 pieces/cm² on average |
| Comparative Example 3 | Class 100 | 0.75 pieces/cm² on average |

As in Example 4, when the clean room of Class 1 using an air filter having a collection efficiency of 99.9999% (6N) or more for dust particles of a size of 0.1µm or more was constructed in the downflow bay system, and the ionizer was set on the ceiling to prevent charge buildup in various substances such as wafers and wafer carriers in the clean room, any particles/foreign substances on the bonding interface could be decreased, and the HF void density could be largely lowered.

In Example 4, DC MODEL442 available from Hugle Electronics was employed as the ionizer and set under a 6N air filter. As an ionizer to be set in an air shower or a compact ionizer to be locally set, an equivalent product available from another company and having a similar neutralization effect may be combined.

Example 4 is associated with a clean room in a bay system in which bays and return spaces alternate. However, the same effect as described above can be expected even when, in a clean room with a double structure, an air filter is set on the entire ceiling surface of the inner room, the outer room is used as a return space, by partitioning at least an area for forming a bonding interface, i.e., an area from cleaning of two substrates to be bonded to bonding by a wall or the like and using a 6N air filter.

Even when a local clean room system such as an SMIF system using a 6N air filter is used in the clean room of Class 100, the same effect as described above can be expected.

In Example 4, after the two substrates were bonded, the non-porous silicon portion 400 was removed by grinding using a grinder or the like. However, as disclosed in Japanese Patent Laid-Open No. 7-302889, the bonded substrate may be separated into two substrates at a middle portion of the porous layer or at a fragile portion which has been formed in the porous layer in advance. Such a fragile portion can be formed in the porous layer by changing, e.g., the current in anodizing.

After the bonded substrate stack is separated into two substrates, the second substrate side, i.e., the support substrate 410 is processed by the automatic thinning/etching line 305 to expose the single-crystal silicon layer (epitaxial layer) 402. The first substrate side, i.e., the p-type single-crystal silicon substrate 400 side can be anodized again and reused after the porous silicon layer is removed. Hence, the manufacturing cost of bonded SOI substrates can be reduced.

When a transparent insulating substrate such as a silica substrate is used as the support substrate, a transparent insulating substrate having a single-crystal silicon layer on the surface can be manufactured.

### (Example 5)

In Example 4, the single-crystal silicon substrate 400 is anodized to form the porous silicon layer 401, and the single-crystal silicon layer 402 is epitaxially grown on the porous silicon layer 401. In Example 5, an ion-implanted layer (micro-cavity layer) is formed in place of the porous layer.

In Example 5 as well, a clean room using an air filter having a collection efficiency of 99.9999% (6N) or more for dust particles of a size of 0.1µm or more was constructed in a downflow bay system, and an ionizer was set on the ceiling to prevent charge buildup in various substances such as wafers and wafer carriers in the clean room.

In Example 5, at least one element of a rare gas, hydrogen, and nitrogen is ion-implanted into a single-crystal silicon substrate to form a porous layer in the single-crystal silicon substrate. A bonded SOI substrate manufacturing method using this method will be referred to as ion implantation peeling hereinafter.

The bonded SOI substrate manufacturing method using ion implantation peeling will be described below. Figs. 5A to 5E are views showing steps of manufacturing a bonded SOI substrate by ion implantation peeling.

In the step shown in Fig. 5A, an insulating layer (SiO₂ layer) 503 is formed on the surface of a single-crystal silicon substrate 500.

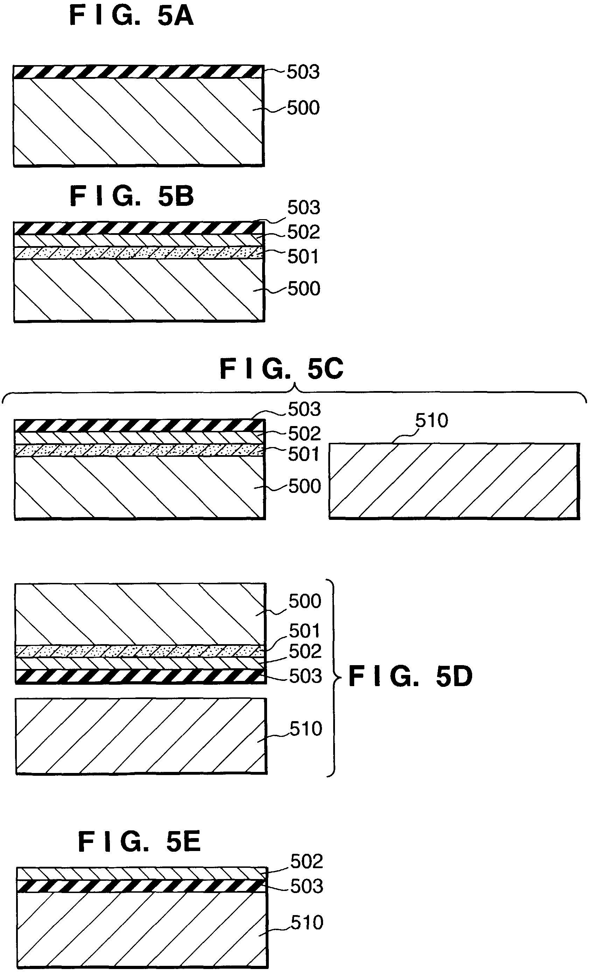

In the step shown in Fig. 5B, hydrogen ions are implanted into the single-crystal silicon substrate 500, and the structure is annealed to form an ion-implanted layer (micro-cavity layer) inside the single-crystal silicon substrate 500. The acceleration energy of ions to be implanted is set such that the projection range has a desired depth. Although the size and density of formed micro cavities change depending on the implantation dose, the implantation dose is preferably about 1 × 10¹⁴ to 1 × 10¹⁵ cm⁻². To set a deep projection range, channeling ion implantation may be performed.

With this process, a first substrate having a single-crystal silicon layer (SOI active layer) 502 under the insulating layer 503 and an ion-implanted layer 501 under the single-crystal silicon layer 502 is formed. The first substrate has almost the same structure as that shown in Fig. 4C. When the ion-implanted layer 501 is observed with a transmission electron microscope, many micro cavities are found.

In Example 5, in a Class 1 clean room of the bay system using a 6N air filter, like Example 4 (Fig. 3), hydrogen ions are implanted using an ion implantation apparatus (not shown). The implantation dose was set to be 1 × 10¹⁵ cm⁻².

In the step shown in Fig. 5C, the first substrate and a support substrate, i.e., a second substrate 510 are prepared and cleaned by an automatic wafer cleaning line.

In the step shown in Fig. 5D, the cleaned substrates are conveyed from an automatic wafer cleaning line 302 to an automatic bonding apparatus 303 and bonded by the automatic bonding apparatus 303.

A SOI substrate may be obtained only by polishing and selective etching, as in Example 4. However, in Example 5, after the bonded substrate stack was separated at the ion-implanted layer 501, the ion-implanted layer left on the support substrate side was polished, thereby obtaining an SOI substrate as shown in Fig. 5E.

When a bonded SOI substrate is manufactured in a clean room with low cleanliness, particles or metal impurities stick to the single-crystal silicon substrate in which ions are to be implanted, and no ions are implanted to that portion. In this case, since a uniform ion-implanted layer 501 cannot be formed on the entire surface, the etching selectivity is lost, and a uniform SOI active layer 502 is difficult to obtain. Even in the process of separating the bonded substrate stack at the ion-implanted layer 501, separation is difficult at a portion where the ion-implanted layer 501 is not uniform, and the substrates may break.

On the other hand, when this process was performed in the clean room of Example 5, a uniform ion-implanted layer 501 could be formed on the entire surface. For this reason, the bonded substrate stack could be satisfactorily separated at the ion-implanted layer 501, and a uniform SOI active layer could be obtained.

As in Example 5, when the clean room using an air filter having a collection efficiency of 99.9999% (6N) or more for dust particles of a size of 0.1µm or more was constructed in the downflow bay system, and the ionizer was set on the ceiling to prevent charge buildup in various substances such as wafers and wafer carriers in the clean room, any particles/foreign substances on the bonding interface could be decreased, and the HF void density could be largely lowered.

The present invention can be applied to another bonded SOI substrate manufacturing method. Examples of another bonded SOI substrate manufacturing method are as follows.

For example, after a first substrate is bonded to a second substrate via an insulating layer such as an oxide film, the lower surface of the first substrate is ground and polished to thin the substrate to about 1 to 3 µm, and the etching region for local plasma etching is scanned while monitoring the film thickness distribution, thereby forming an SOI layer.

Alternatively, a p⁺-type Si thin film which contains boron at a high concentration and p-type Si thin film are formed on a p-type substrate by, e.g., epitaxial growth to prepare a first substrate. After the first substrate is bonded to a second substrate via an insulating layer such as an oxide film, the lower surface of the first substrate is ground and polished. After this, the remaining p-type Si thin film is selectively etched to expose the p⁺-type Si thin film, and the p⁺-type Si thin film is selectively etched to expose the p-type Si thin film, thereby completing an SOI structure.

In these manufacturing methods as well, when SOI substrates are manufactured in a Class 1 clean room of the bay system using an air filter having a collection efficiency of 99.9999% (6N) or more for dust particles of a size of 0.1µm or more, as in Example 5, the same effect as described above can be expected.

When a transparent insulating substrate such as a silica substrate is used as the support substrate, a transparent insulating substrate having a single-crystal silicon layer on the surface can be manufactured.

### (Effect of First Embodiment)

According to this embodiment, when a clean room with cleanliness of Class 1 or more in the Fed. St. 209D: USA IS standard is constructed using an air filter having a collection efficiency of 99.9999% (6N) or more for dust particles of a size of 0.1µm or more, and a bonded SOI substrate is manufactured while exposing the bonding interface to only clean air, dust particles/foreign substances can be prevented from sticking to the bonding interface, and a high-quality bonded SOI substrate can be manufactured.

In addition, when charge buildup in substances in the clean room prevented, dust particles/foreign substances can be further prevented from sticking to the bonding interface, and a higher-quality bonded SOI substrate can be manufactured.

According to the bonded SOI substrate manufacturing method of this embodiment, the density of HF voids formed upon immersing the structure in a 49% concentrated HF solution for 15 min is, e.g., 0.5 pieces/cm² or less.

As described above, according to this embodiment, high-quality bonded SOI substrates can be manufactured at high yield, and the manufacturing cost can be largely reduced.

### [Second Embodiment]

In the second embodiment, the bonded SOI substrate manufacturing method of the first embodiment is further improved.

More specifically, in this embodiment, a bonded SOI substrate is manufactured without exposing the bonding interface between substrates to be bonded to any atmospheres other than clean air circulated through a highly efficient air filter using a chemically stable PTFE (polytetrafluoroethylene) filter medium (to be referred to as a PTFE air filter hereinafter). According to this manufacturing method, foreign substances such as dust can be prevented from sticking to the bonding interface in substrate, and a change in properties of an SOI layer due to a chemical such as hydrofluoric acid used in substrate cleaning or etching can be decreased.

In the manufacturing system of this embodiment, a PTFE air filter is used as an air filter, thereby eliminating generation of dust from the air filter or generation of chemical impurities such as boron. In this manufacturing system, not only the PTFE air filter but also a chemical filter is inserted between an apparatus for forming a bonding interface (i.e., the surface layers of first and second substrates) and a bonding apparatus for bonding the two substrates. With this arrangement, chemical impurities that enter from the exterior or are generated in a small amount from human bodies, wall material, or floor covering material and float in air are removed to eliminate contamination of the bonding interface by boron. Hence, the amount of boron on the bonding interface can be decreased to 1 × 10¹⁶ atoms/cm³ or less.

In the manufacturing system of this embodiment, the PTFE air filter set on the upstream of a vertical downflow with a controlled airflow velocity has a collection efficiency of 99.99999% (7N) or more for dust particles of a size of 0.1µm or more, so a clean room of Class 1, i.e., a clean room in which 39 or less dust particles each having a size of 0.1-µm or more are present per cubic foot is constructed.

The manufacturing system of this embodiment also takes charge buildup in the clean room into consideration. In cleaning of silicon wafers and, more particularly, in drying after cleaning, rotary drying is performed while spraying an enormous amount of air to the wafers. At this time, static electricity of several thousand V or more is generated due to friction between the large quantity of air and wafers to attract dust. In the clean room, antistatic fixtures are used. However, many wafer carriers or conveyor boxes made of Teflon, which are used to store or convey wafers, or rubber or vinyl gloves having insulating properties are still used without any antistatic treatment. Charge builds up in these fixtures by friction and attracts light dust in the ambient.

In the manufacturing system of this embodiment, a mechanism for minimizing charge buildup in any substances in the clean room is used to prevent dust from adhering to any substances. Especially, in the manufacturing system of this embodiment, sticking of dust particles/foreign substances to the bonding interface is minimized.

The manufacturing method of the present invention can be implemented even in a conventional clean room with cleanliness of Class 100 to 1000 by employing a local clean room system such as SMIF (Standard Mechanical InterFace).

The local clean room system such as SMIF uses an inter-apparatus conveyance local clean box system having an outer clean room, a wafer loading mechanism for loading wafers into an isolated apparatus, and a wafer recovering mechanism. According to this system, substrates being manufactured are not exposed to the outer clean room atmosphere of Class 100 to 1000 where an air filter using glass fibers as a filtering medium is used.

When a bonded SOI substrate manufactured by the method of this preferred embodiment of the present invention is dipped in a 49% concentrated HF solution for 15 min, the HF void density is 0.5 pieces/cm² or less.

The HF void density of 0.5 pieces/cm² or less corresponds to a cleanliness with which 39 or less dust particles each having a size of 0.1-µm or more are present per cubic foot (cleanliness of Class 1 or more in Fed. St. 209D: USA IS standard), i.e., 0.00137 or less dust particles each having a size of 0.1-µm or more are present per cubic centimeter.

Assume that dust particles are uniformly distributed, and a wafer is left to stand in a vertical downflow with a normal airflow velocity of 40 cm/s. In this case, 0.55 pieces of dust particles pass through the wafer per unit area in 10 sec. More specifically, in the clean room of Class 1 in the USA IS standard, when a wafer is left to stand perpendicular to the vertical downflow with an airflow velocity of 40 cm/s for 10 sec, 0.55/cm² dust particles may be sprayed to the wafer.

In the manufacturing system of this embodiment, wafers parallel to the floor surface, i.e., perpendicular to the vertical downflow are extracted from a wafer carrier and bonded on a stage. The time required to extract the wafers from the wafer carrier and bond them is 10 sec or less. Assuming that all dust particles sprayed to the substrates during this time form HF voids, the HF void density upon bonding the wafers in the clean room of Class 1 in the USA IS standard within 10 sec is probably 0.5 pieces/cm².

Specific examples of this embodiment will be described below.

### (Example 1)

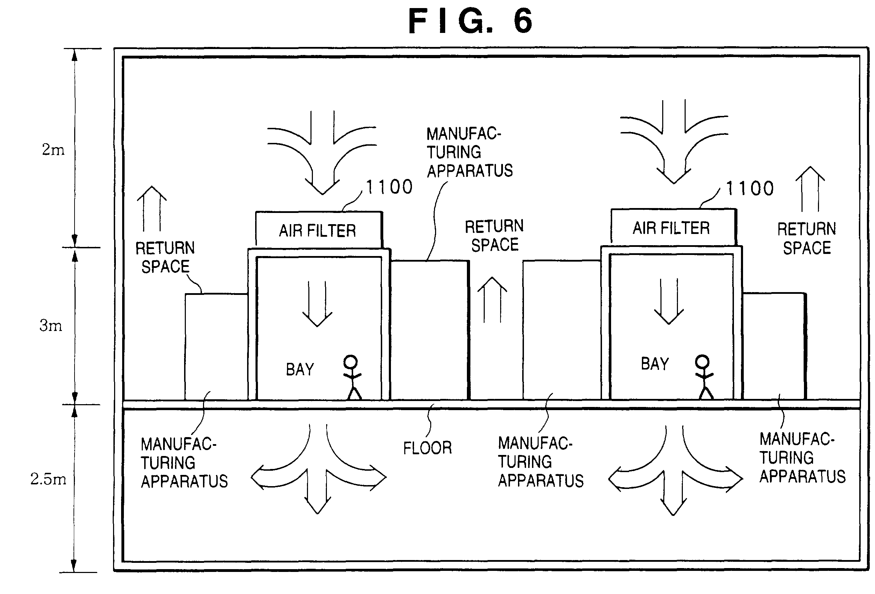

Fig. 6 is a sectional view showing the schematic arrangement of a clean room of Example 1 of the second embodiment. The clean room of Example 1 has various apparatuses for manufacturing a bonded SOI substrate.

In Example 1, air is circulated through a chemically stable PTFE air filter 1100 to realize a clean room of Class 1.

A PTFE filter medium has been described in detail in "Electronic Material, August 1996". There is an air filter having a filter medium of glass fiber (to be referred to as a glass air filter). However, since the strength becomes low when only fragile and thin glass fibers are used, glass fibers mixed with thick glass fibers are used as a filter medium of a glass air filter. Since the glass air filter has a nonuniform filter medium, the collection performance is poor.

The PTFE filter medium consists of fibers of even diameter, and has small holes between the fibers because it is formed by stretching a PTFE resin film. The particle collection efficiency of the PTFE air filter is higher than a conventional glass air filter having the same pressure loss as that of the PTFE air filter by about three orders of magnitudes.

A glass filter medium contains a large quantity of boron or a metal oxide to obtain high molding properties in fabricating the filter media fibers. This is because the softening temperature of 100% silica glass is too high, and mass production of thin glass fibers is difficult. Consequently, when the filter medium is submerged in pure water, impurities are eluted in a large amount. When air is filtered with the glass filter medium, gaseous chemical impurities such as boron are produced. Especially when they come into contact with hydrofluoric acid which is normally used for substrate cleaning or etching in the clean room, such chemical impurities increase.

The chemically stable air filter using the PTFE filter medium used in Example 1 does not change in properties by such an acid, and dust from the air filter or chemical impurities such as boron are completely eliminated.

In Example 1, as shown in Fig. 6, a clean room is built using the PTFE air filter 1100 in the downflow bay system. The PTFE air filter has a collection efficiency of 99.99999%(7N) or more for dust particles of a size of 0.1µm or more.

More specifically, this clean room has an underfloor space of 2.5 m, a floor space of 3.0 m, and a ceiling space of 2.0 m. In this clean room, the underfloor space and floor space are partitioned by floor with a mesh structure (grating floor) through which air can pass. In the bay area, the PTFE air filter 1100 is set in the ceiling. Clean air passing through the PTFE air filter 1100 is sent from the ceiling to the floor and then to the underfloor through the floor as a vertical downflow with an airflow velocity of 0.3 to 0.45 m/s.

The air sent to the underfloor returns to the ceiling through the return space next to the bay area and circulates again through the PTFE air filter 1100. The return space and bay area are completely partitioned by a wall or through the wall structure on the floor. An air filter in each manufacturing apparatus is also constituted by a PTFE air filter. Hence, substrates being manufactured are exposed to only clean air passing through the PTFE air filter.

In the clean room with the above arrangement, 39 or less dust particles each having a size of 0.1-µm or more are present per cubic foot (0.00137 or less dust particles each having a size of 0.1-µm or more are present per cubic centimeter), so cleanliness of Class 1 or more in Fed. St. 209D: USA IS standard is realized. At each of 29 measurement points in the bay area, 1 cubic foot or more of air was sampled, and the particle density in the air was measured three times using a dust counter capable of measuring 0.1-µm or more particles. The particle density was 0 particle/cubic foot at all points.

Table 4 shows HF void densities obtained when a bonded SOI substrate manufactured in the clean room of Class 1 shown in Fig. 6 and a bonded SOI substrate manufactured in a clean room of Class 100 using a glass air filter (Comparative Example 1) were etched using concentrated hydrofluoric acid (49%) for 15 min. Both bonded SOI substrates had an SOI film thickness of 200 nm and a buried oxide film thickness of 200 nm.

**Table 4**

| | Air filter | Clean room | HF void density |
|---|---|---|---|
| Example | PTFE filter medium | Class 1 or more | 0.11 pieces/cm² on average |
| Comparative Example 1 | Glass filter medium | Class 100 | 0.89 pieces/cm² on average |

As shown in Table 4, when the clean room of Class 1 using a PTFE air filter was constructed in the downflow bay system, the particles/foreign substances on the bonding interface could be decreased, and the HF void density could be largely lowered.

In Example 1, a PTFE filter media air filter (Neurofine) available from DAIKIN Industries was used. However, an air filter having an equivalent performance and available from Nihon Muki or the like can also be employed.

Example 1 is associated with a clean room in a bay system in which bays and return spaces alternate. However, the same effect as described above can be expected by employing a PTFE air filter as an air filter even when, in a clean room with a double structure, an air filter is set on the entire ceiling surface of the inner room, and the outer room is used as a return space.

### (Example 2)

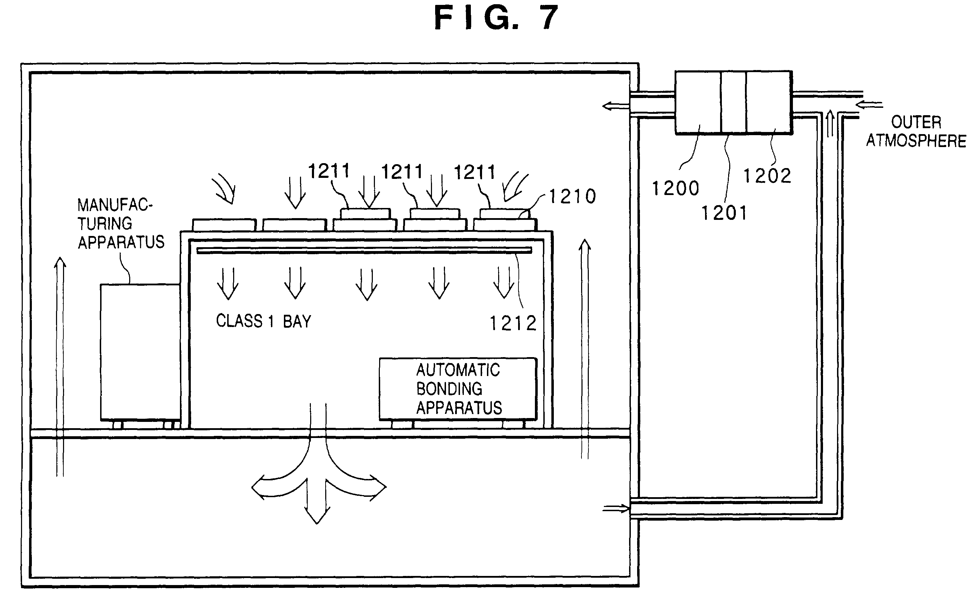

Fig. 7 is a sectional view showing the schematic arrangement of a clean room of Example 2 of the second embodiment. The clean room of Example 2 has not only apparatuses shown in Fig. 7 but also various apparatuses for manufacturing a bonded SOI substrate.

As described above, a PTFE filter media is chemically stable and does not change in properties even when it comes into contact with hydrofluoric acid or the like, so a chemical impurity such as boron neither is eluted nor floats in air. However, a very small amount of an external chemical impurity such as boron may enter. In Example 2, as shown in Fig. 7, a chemical filter 1201 is arranged in front of an air conditioner 1200 for introducing the outer atmosphere. Reference numeral 1202 denotes an air filter.

Chemical impurities may not be completely removed with the air conditioner 1200 for introducing outer atmosphere, and there are also a small amount of chemical impurities generated from human bodies, wall material, or floor covering material. In Example 2, not only PTFE air filters 1210 but also chemical filters 1211 are locally set on the ceiling in at least an area from bonding interface formation to bonding, i.e., from an apparatus for cleaning two substrates (first and second substrates) to be bonded to an apparatus for bonding the substrates. With the chemical filters 1211, chemical impurities such as boron which may enter from the outside or generated in a small amount from human bodies, wall material, or floor covering material can be suppressed from sticking to the bonding interface. In Example 2, as the chemical filters 1201 and 1211, chemical adsorption type chemical filters using ion exchange were used.

In Table 5, the component concentrations of chemical impurities in a clean room using a glass air filter and without any chemical filter (Comparative Example) and the component concentrations of chemical impurities at the outlet of the air conditioner 1200 and the inlet and outlet of the chemical filter 1211 in the clean room of Example 2 are compared.

**Table 5**

| | Na⁺ | NH₄⁺ | K⁺ | Cl⁻ | SO₄⁻ | B | P |
|---|---|---|---|---|---|---|---|
| Comparative Example | 0.7 | 4.6 | 0.07 | 3.4 | 10.9 | 0.3 | 0.03 |
| Example: air conditioner outlet | 0.007 | 1.9 | <0.003 | 0.3 | 0.07 | 0.08 | 0.003 |
| Example: chemical filter inlet | <0.001 | 3.6 | <0.003 | 0.38 | 0.56 | 0.01 | 0.003 |
| Example: chemical filter outlet | <0.001 | 1.1 | <0.003 | 0.08 | <0.05 | 0.001 | 0.002 |

According to the clean room of Example 2, by using the PTFE air filter 1210, the amount of chemical impurities can be decreased by one order of magnitude or more as compared to that in the conventional clean room. Immediately under the chemical filter 1211, the amount of chemical impurities can be further decreased by about one order of magnitude.

The concentration of NH₄⁺ or the like increases at the inlet of the chemical filter 1211 because it is generated from the wall material or human bodies in the clean room, although it is removed by the chemical filter 1201 before the air conditioner 1200. However, NH₄⁺ or the like is removed by the chemical filter 1211.

In Example 2, in the process of bonding two substrates, an automatic bonding apparatus is used to prevent chemical impurities which may come together with human bodies from sticking to substrates.

Table 6 shows the boron concentrations in SOI active layers of a bonded SOI substrate manufactured in the clean room of Example 2 and a bonded SOI substrate manufactured in a clean room of Class 100 using a glass air filter of Comparative Example shown in Table 5 (Comparative Example 2), which were obtained by SIMS analysis.

**Table 6**

| | Air filter | Chemical filter | Boron concentration in SOI active layer |
|---|---|---|---|
| Example | PTFE filter medium | Present | 10¹⁵ to 10¹⁶ atoms/cm³ |
| Comparative Example 2 | Glass filter medium | Absent | 10¹⁸ to 10¹⁹ atoms/cm³ |

In the clean room using the glass air filter, a large amount of boron is eluted from the glass filter medium by hydrofluoric acid. For this reason, boron adheres to the bonding interface at 10¹⁹ atoms/cm³, as shown in Table 6. On the other hand, in Example 2, at least in the process of forming a bonding interface, i.e., in the process from cleaning two substrates to be bonded to bonding, chemical filters are used in addition to the PTFE air filters. With this arrangement, chemical impurities such as boron can be prevented from sticking to the bonding interface and diffusing into the SOI active layer.

Boron or the like diffused from the bonding interface into the SOI active layer impedes the manufacture of a device. The concentration of boron diffused into the SOI active layer can be lowered by annealing the SOI substrate to externally diffuse boron. However, to externally diffuse boron at 10¹⁸ to 10¹⁹ atoms/cm³, annealing must be performed for a long time. It is not easy especially for a thick bonded SOI substrate.

In Comparative Example 2, chemical impurities other than boron may also enter the SOI active layer from the bonding interface. In Example 2, however, such a risk can be avoided because of use of chemical filters, so a high-quality SOI active layer can be formed.

In Example 2, in the Class 1 bay area, i.e., area where a substrate being manufactured process is exposed, an ionizer 1212 is set on the ceiling to prevent charge buildup in various substances, as shown in Fig. 7.

In Example 2, in the bay area of Class 1, i.e., in an area where substrates being manufactured are exposed, an ionizer 1212 for preventing charge buildup in various substances in the clean room is arranged on the ceiling, as shown in Fig. 7. With the neutralization effect by the ionizer 1212, particles can be prevented from sticking to wafers, wafer carriers, and the like.

In respect of charge buildup in the clean room, caution must be exercised in cleaning silicon wafers and, more particularly, in drying after cleaning. In drying, rotary drying is performed while spraying an enormous amount of air to the wafers. At this time, static electricity of several thousand V or more is generated due to friction between the large quantity of air and wafers to attract dust. In the clean room, antistatic fixtures are used. However, many wafer carriers or conveyor boxes made of Teflon, which are used to store or convey wafers, or rubber or vinyl gloves having insulating properties are still used without any antistatic treatment. Charged builds up in these fixtures are by friction and attracts light dust in the vicinity

The ionizer generates charges necessary for neutralization, i.e., charges having a polarity opposite to that of charged substances and supplies the charges to the charged substances for neutralization. The charges with opposite polarity are generated by ionizing gas molecules with an electric energy such as an electric field to generate ion pairs.

In Table 7, HF void densities obtained when a bonded SOI substrate manufactured in the clean room shown in Fig. 7 and a bonded SOI substrate manufactured in a conventional clean room of Class 100 using a glass air filter (Comparative Example 1) were etched using concentrated hydrofluoric acid (49%) for 15 min are compared. Both bonded SOI substrates had an SOI film thickness of 200 nm and a buried oxide film thickness of 200 nm.

**Table 7**

| | Air filter | Clean room | Ionizer | HF void density |
|---|---|---|---|---|
| Example | PTFE filter medium | Class 1 | Present | 0.05 pieces/cm² on average |
| Comparative Example 1 | Glass filter medium | Class 100 | Absent | 0.89 pieces/cm² on average |

As shown in Table 7, when the clean room of Class 1 using PTFE air filters was constructed in the downflow bay system, and the ionizer was set on the ceiling to prevent charge buildup in various substances such as wafers and wafer carriers in the clean room, the particles/foreign substances on the bonding interface could be decreased, and the HF void density could be largely lowered.

In Example 2, as the chemical filters 1211, chemical adsorption type chemical filters (EPIX available from Ebara) using ion exchange were used and locally arranged in the area from cleaning of two substrates to be bonded to bonding. Chemical filters may be arranged throughout the clean room. In addition, depending on the chemical components, the same effect can be obtained by using other chemical filters such as physical adsorption or neutralization type chemical filters, and these filters may be combined.

In Example 2, DC MODEL442 available from Hugle Electronics was employed as the ionizer 1212 and set under the air filter 1210. As an ionizer to be set in an air shower or a compact ionizer to be locally set, an equivalent product available from another company and having a similar neutralization effect may be combined.

Example 2 is associated with a clean room in a bay system in which bays and return spaces alternate. However, the same effect as described above can be expected even when, in a clean room with a double structure, an air filter is set on the entire ceiling surface of the inner room, the outer room is used as a return space, by partitioning at least an area for forming a bonding interface, i.e., an area from cleaning of two substrates to be bonded to bonding by a wall or the like and using a PTFE air filters and chemical filters.

### (Example 3)

In Example 3, in a clean room of Class 100 using a glass air filter, an SMIF system having a PTFE air filter in a manufacturing apparatus is employed, and an SMIF system having a PTFE air filter and a chemical filter is employed for conveyance of wafers in an apparatus and between apparatuses for forming a bonding interface and bonding wafers.

The SMIF system has not only a semiconductor manufacturing apparatus with an SMIF pod and an SMIF enclosure but also robots such as an SMIF arm and an SMIF loader.

The SMIF pod is a case/container with a good seal used to convey or store wafer carrier and contains a clean inert gas or the like. A wafer carrier in the SMIF pod is inserted/extracted to/from the semiconductor manufacturing apparatus in the SMIF enclosure of a local clean room having a PTFE air filter by a wafer carrier loading mechanism and dedicated robots such as an SMIF arm and SMIF loader having a recovery mechanism. The outer clean room and wafers, or human bodies and wafers are completely isolated from each other.

An apparatus for performing a process after bonding interface formation and until bonding, and an SMIF enclosure between apparatus also preferably has a PTFE air filter and a chemical filter.

Even when the local clean room system such as the SMIF system is employed, the same effect as in Examples 1 and 2 can be obtained by setting the same environment as in Examples 1 and 2, to which wafers are exposed.

### (Example 4)

Example 4 is associated with ELTRAN as a method of manufacturing a bonded SOI substrate. In ELTRAN, the front surface side of a first substrate having a porous layer on the surface and a non-porous layer containing a single-crystal layer on the porous layer is bonded to an independently prepared second substrate. After this, the first substrate side is removed, and the porous layer left on the surface on the second substrate side is selectively removed, thereby transferring the single-crystal layer on the first substrate to the second substrate.

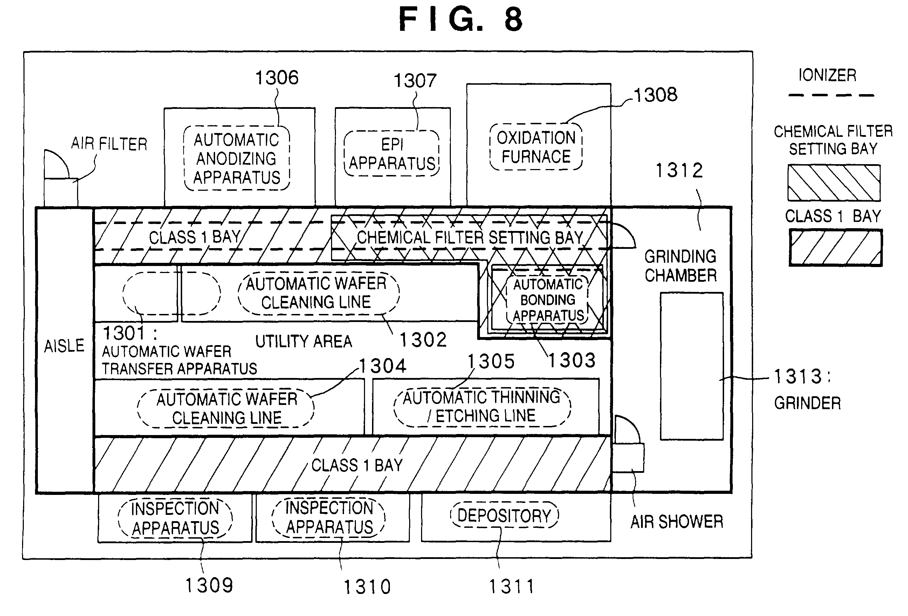

Fig. 8 is a plan view showing the schematic arrangement of a clean room for manufacturing a bonded SOI substrate by ELTRAN.

The clean room shown in Fig. 8 is a clean room of the bay system. Referring to Fig. 8, the area of "Class 1 bay" is an area where a PTFE air filter is set on the entire ceiling surface, and a vertical downflow of clean air having a controlled airflow velocity of about 0.3 to 0.45 m/s is formed.

More specifically, this clean room has an underfloor space of 2.5 m, a floor space of 3.0 m, and a ceiling space of 2.0 m. In this clean room, the underfloor space and floor space are partitioned by floor with a mesh structure (grating floor) through which air passes. In the bay area, a PTFE air filter is set in the ceiling. Clean air passing through the PTFE air filter is sent from the ceiling to the floor and then to the underfloor through the floor as a vertical downflow with an airflow velocity of 0.3 to 0.45 m/s. The air sent to the underfloor returns to the ceiling through the return space (utility area) next to the bay area and circulates again through the PTFE air filter. The return space and bay area are completely partitioned by a wall or through the wall structure on the floor.

A filter in each of manufacturing apparatuses 1301 to 1308 is also constituted by a PTFE air filter. Hence, substrates during the manufacturing process are exposed to only clean air passing through the PTFE air filter.

In the clean room of Example 4, 39 or less dust particles each having a size of 0.1-µm or more are present per cubic foot (0.00137 or less dust particles each having a size of 0.1-µm or more are present per cubic centimeter), so cleanliness of Class 1 or more in Fed. St. 209D: USA IS standard is realized. At each of 29 measurement points in the bay area, 1 cubic foot or more of air was sampled, and the particle density in the air was measured three times using a dust counter capable of measuring 0.1-µm or more particles. The particle density was 0 particle/cubic foot at all points. In the manufacturing apparatuses 1301 to 1308 as well, cleanliness of Class 1 or more in Fed. St. 209D: USA IS standard is realized.

As described above, the PTFE air filter is chemically stable and does not change in properties even when it comes into contact with hydrofluoric acid or the like, so a chemical impurity such as boron neither is eluted nor floats in air. However, a very small amount of an external chemical impurity such as boron may enter. In Example 4, a chemical filter was used as a pre-filter in front of an air conditioner for introducing the outer atmosphere, as in Example 2.

Chemical impurities may not be completely removed with the air conditioner for introducing outer atmosphere, and there are also a small amount of chemical impurities generated from human bodies, wall material, or floor covering material. In Example 4, as shown in Fig. 8, not only PTFE air filters but also chemical filters are locally set on the ceiling in at least an area from bonding interface formation to bonding, i.e., from an apparatus for cleaning two substrates (first and second substrates) to be bonded to an apparatus for bonding the substrates. With the chemical filters, chemical impurities such as boron which may enter from the outside or generated in a small amount from human bodies, wall material, or floor covering material can be suppressed from sticking to the bonding interface. In Example 4, chemical adsorption type chemical filters using ion exchange were used.

Not only the PTFE air filters but also chemical filters are set on the entire ceiling surface of an area from the wafer delivery section of the automatic wafer cleaning line 1302 to the automatic bonding apparatus 1303, i.e., in the "chemical filter set bay" in Fig. 8.

In Example 4, the apparatus for forming a bonding interface and an apparatus for processing it and, more specifically, the oxidation furnace 1308 and the epitaxial growth apparatus (Epi apparatus) 1307 use CRP tubes partially in gas pipelines, thereby removing metal impurities.

In addition, an ionizer is set on the ceiling of the Class 1 bay in which the automatic anodizing apparatus 1306, the epitaxial growth apparatus (Epi apparatus) 1307, the oxidation furnace 1308, the automatic wafer transfer apparatus 1301, the automatic wafer cleaning line 1302, and the automatic bonding apparatus 1303 are arranged on both sides. The ionizer neutralizes wafers or wafer carriers in which charge has built up upon loading/unloading wafers.

Steps of manufacturing a bonded SOI substrate by ELTRAN in the clean room shown in Fig. 8 will be described below. Figs. 4A to 4F are views showing steps of manufacturing a bonded SOI substrate by ELTRAN.

In the step shown in Fig. 4A, a single-crystal silicon substrate 400 is anodized by the automatic anodizing apparatus 1306 to form a porous silicon layer 401. At this time, the thickness of the porous layer on the single-crystal silicon substrate 400 is preferably, e.g., several µm to several ten µm. However, the substrate may be wholly anodized.

To form a porous silicon layer, a p-type single-crystal silicon substrate 400 is preferably prepared. An n-type single-crystal silicon substrate may be used. In this case, however, a substrate having a low resistance must be prepared, or generation of holes must be prompted in anodizing by irradiating the substrate surface with light.

As an anodizing solution used to anodize the single-crystal silicon substrate 400, a mixed solution of an alcohol and hydrofluoric acid having higher concentration than that of hydrofluoric acid for cleaning is used. In the clean room of Example 4, PTFE air filters are employed, and therefore, the filter medium does not change by the anodizing solution to elute chemical impurities or generate particles.

In Example 4, the p-type single-crystal silicon substrate 400 was cleaned by the automatic wafer cleaning line 1302, and then, one surface of the p-type single-crystal silicon substrate 400 was anodized by the automatic anodizing apparatus 1306 by about 10 µm to form a porous silicon layer 401.

In the step shown in Fig. 4B, a non-porous single-crystal silicon layer 402 is epitaxially grown on the porous silicon layer 401. Epitaxial growth can be performed by general thermal CVD, low-pressure CVD, plasma CVD, molecular beam epitaxial growth, or sputtering. In Example 4, the pore wall portions in the porous single-crystal silicon layer 401 were slightly surface-oxidized by the oxidation furnace 1308, and then, the single-crystal silicon layer 402 was formed by the epitaxial growth apparatus (Epi apparatus) 1307 next to the oxidation furnace 1308. The thickness of the epitaxially grown layer is designed in consideration of the SOI active layer, the amount be consumed by the buried oxide film, and the amount to be decreased upon cleaning.

In Example 4, the gas pipeline of the epitaxial growth apparatus (Epi apparatus) 1307 uses a CRP tube to remove metal impurities, thereby preventing the metal impurities from mixing during epitaxial growth.

In the step shown in Fig. 4C, the surface of the single-crystal silicon layer (epitaxial layer) 402 is oxidized by the oxidation furnace 1308 to form a buried oxide film 403 having a predetermined thickness. In Example 4, the oxidation furnace 1308 uses a CRP tube partially in the gas pipeline to remove metal impurities, thereby preventing the metal impurities from mixing during formation of the oxide film.

In the step shown in Fig. 4D, the substrate 400, i.e., a first substrate on which the porous silicon layer 401, single-crystal silicon layer 402, and oxide film 403 are formed, and a silicon substrate 410 as a second substrate are prepared. As the support substrate 410, not only a substrate having an oxidized surface, a silica glass substrate, or a crystallized glass substrate but also a substrate prepared by forming an oxide film on an arbitrary substrate can be selected. In Example 4, as the support substrate, a silicon substrate whose surface was not oxidized was selected, and the substrate 400 on which the porous silicon layer 401, single-crystal silicon layer 402, and oxide film 403 were formed and the silicon substrate (support substrate) 410 were cleaned by the automatic wafer cleaning line 1302.

One or both of the first and second substrates may be exposed to a plasma atmosphere to activate the surface oxide film and improve the bonding strength. As a gas, oxygen is preferably used. Alternatively, a gas such as air (mixed gas of oxygen and nitrogen), nitrogen, or hydrogen, an inert gas such as argon or helium, or a molecular gas such as ammonia may be used.

In the step shown in Fig. 4E, the cleaned substrates are conveyed from the automatic wafer cleaning line 1302 to the automatic bonding apparatus 1303 and bonded by the automatic bonding apparatus 1303. In the clean room of Example 4, not only PTFE air filters but also chemical filters are set on the entire ceiling surface of an area from the unloader portion of the automatic wafer cleaning line 1302 to the automatic bonding apparatus 1303. Hence, contamination of the bonding interface is minimized.

Subsequently, the bonded substrate stack is heated to increase the bonding strength. Annealing temperature is preferably high to some extent. However, if the temperature is excessively high, the structure of the porous silicon layer 401 may change, or an impurity contained in the substrate may diffuse into the single-crystal silicon layer (epitaxial layer) 402. For this reason, a temperature and time which do not pose such a problem must be selected. More specifically, a temperature of 1,200°C or less is preferable.

Some substrates cannot be treated at high temperatures. For example, when the support substrate 410 is a silica glass substrate, this substrate must be annealed at a temperature of about 200°C or less because of the difference in thermal expansion coefficient between silicon and silica glass. At higher temperatures, the bonded substrate stack may peel or break by stress. However, a bonding interface which can withstand stress in the next grinding or etching process of the bulk silicon 400 need only be obtained by annealing. Hence, when the surface treatment conditions in activation are optimized, annealing temperature can be set at 200°C or less.

In the step shown in Fig. 4F, the non-porous single-crystal silicon portion 400 and porous silicon layer 401 are selectively removed to leave the single-crystal silicon layer (epitaxial layer) 402. With this process, an SOI substrate having a satisfactory film thickness distribution is completed.

In this process, the non-porous single-crystal silicon portion 400 is ground by a grinder 1313 or the like in a grinding chamber 1312 by about several hundred µm, and then dry-etched by about several µm by RIE (Reactive Ion Etching) to expose the porous layer 402. The entire non-porous single-crystal silicon portion 400 may be removed only by grinding using a grinder or the like or only by RIE dry etching to expose the porous silicon layer 402.

The single-crystal silicon portion 400 is ground in the grinding chamber 1312 partitioned by a wall. The grinding chamber 1312 need not ensure the cleanliness of Class 1. However, when a glass air filter is used, chemical impurities may diffuse to the Class 1 bay. To prevent this, in Example 4, a PTFE air filter is partially set on the ceiling of the grinding chamber 1312. In Example 4, cleanliness of the grinding chamber 1312 is roughly Class 100.

The porous silicon layer 402 is exposed and then selectively etched by an automatic thinning/etching line 1305 to leave the single-crystal silicon layer (epitaxial layer) 402. The etching rate for porous silicon is 10⁵ to 10⁶ times that for non-porous silicon. For this reason, when a number of wafers are subjected to a batch process in units of wafer carriers in the automatic thinning/etching line 1305, SOI substrates having a satisfactory film thickness distribution can be obtained.

Etching of porous silicon progresses rapidly when the pore walls abruptly break by the etching function of an etchant entering the pores. Hence, the etching selectivity ratio of porous silicon to non-porous silicon reaches 10⁵ to 10⁶ times. The underlying single-crystal silicon layer (epitaxial layer) 402 is formed from non-porous silicon and therefore etched little because the etching rate is smaller than that for porous silicon by five to six orders of magnitudes. The single-crystal silicon layer 402 is left as a uniform SOI thin film maintaining the film thickness uniformity upon epitaxial growth.

With the above process, an SOI substrate having a satisfactory film thickness distribution is completed. In Example 4, the SOI substrate is cleaned by the automatic wafer cleaning line 1304, and then, hydrogen annealing is performed to planarize the surface.

To prevent boron contaminating the anodized p-type single-crystal silicon substrate 400 from diffusing into the SOI active layer, hydrogen annealing is done to externally diffuse boron. In Example 4, however, since contamination of the bonding interface by chemical impurities such as boron is minimum, hydrogen annealing for externally diffusing boron is performed while considering the amount of diffusion from the anodized p-type single-crystal silicon substrate.

A bonded SOI substrate manufactured in the clean room of Example 4 and a bonded SOI substrate manufactured in a clean room of Class 100 using a glass air filter (Comparative Example 3) were etched using concentrated hydrofluoric acid (49%) for 15 min. Table 8 shows the HF void densities at this time and boron concentrations in the SOI active layers obtained by SIMS analysis. Both bonded SOI substrates had an SOI film thickness of 200 nm and a buried oxide film thickness of 200 nm.

**Table 8**

| | Clean room system | HF void density | Boron concentration in SOI active layer |
|---|---|---|---|
| Example | PTFE air filter + chemical filter | 0.02 pieces/cm² on average | 10¹⁵ to 10¹⁶ atoms/cm³ |
| Comparative Example 3 | conventional Class 100 | 0.75 pieces/cm² on average | 10¹⁸ to 10¹⁹ atoms/cm³ |

As in Example 4, when the clean room of Class 1 using PTFE air filters was constructed in the downflow bay system, and the ionizer was set on the ceiling to prevent charge buildup in various substances such as wafers and wafer carriers in the clean room, any particles/foreign substances on the bonding interface could be decreased, and the HF void density could be largely lowered.

In Example 4, a PTFE filter media air filter (Neurofine) available from DAIKIN Industries was used. However, an air filter having an equivalent performance and available from Nihon Muki or the like can also be employed.

In Example 4, chemical adsorption type chemical filters (EPIX available from Ebara) using ion exchange were locally arranged in the system from cleaning of substrates (first and second substrates) to be bonded to bonding. Chemical filters may be arranged throughout the clean room.

In addition, depending on the chemical components, the same effect can be obtained by using other chemical filters such as physical adsorption or neutralization type chemical filters, and these filters may be combined.

In Example 4, DC MODEL442 available from Hugle Electronics was employed as the ionizer and set under the air filter. As an ionizer to be set in an air shower or a compact ionizer to be locally set, an equivalent product available from another company and having a similar neutralization effect may be combined.

Example 4 is associated with a clean room in a bay system in which bays and return spaces alternate. However, the same effect as described above can be expected even when, in a clean room with a double structure, an air filter is set on the entire ceiling surface of the inner room, the outer room is used as a return space, by partitioning at least an area for forming a bonding interface, i.e., an area from cleaning of two substrates to be bonded to bonding by a wall or the like and using a PTFE air filters and chemical filters.

The same effect as described above can be expected even when, in a Class 100 clean room using an air filter with a glass filter media, a local clean room system such as an SMIF system with PTFE air filters in the manufacturing apparatuses is used, and PTFE air filters and chemical filters are used for conveyance in an apparatus or between apparatuses for performing processes from bonding interface formation to bonding.

In Example 4, after the two substrates were bonded, the non-porous silicon portion 400 was removed by grinding using a grinder or the like. However, as disclosed in Japanese Patent Laid-Open No. 7-302889, the bonded substrate may be separated into two substrates at a middle portion of the porous layer or at a fragile portion which has been formed in the porous layer in advance. Such a fragile portion can be formed in the porous layer by changing, e.g., the current in anodizing.

After the bonded substrate stack is separated into two substrates, the second substrate side, i.e., the support substrate 410 is processed by the automatic thinning/etching line 1305 to expose the single-crystal silicon layer (epitaxial layer) 402. The first substrate side, i.e., the p-type single-crystal silicon substrate 400 side can be anodized again and reused after the porous silicon layer is removed. Hence, the manufacturing cost of bonded SOI substrates can be reduced.

When a transparent insulating substrate such as a silica substrate is used as the support substrate, a transparent insulating substrate having a single-crystal silicon layer on the surface can be manufactured.

### (Example 5)

In Example 4, the single-crystal silicon substrate 400 is anodized to form the porous silicon layer 401, and the single-crystal silicon layer 402 is epitaxially grown on the porous silicon layer 401. In Example 5, an ion-implanted layer (micro-cavity layer) is formed in place of the porous layer.

In Example 5 as well, a clean room of Class 1 using PTFE air filters was constructed in a downflow bay system, and an ionizer was set on the ceiling to prevent charge buildup in various substances such as wafers and wafer carriers in the clean room.

In Example 5, at least one element of a rare gas, hydrogen, and nitrogen is ion-implanted into a single-crystal silicon substrate to form a porous layer in the single-crystal silicon substrate. A bonded SOI substrate manufacturing method using this method will be referred to as ion implantation peeling hereinafter.

The bonded SOI substrate manufacturing method using ion implantation peeling will be described below. Figs. 5A to 5E are views showing steps of manufacturing a bonded SOI substrate by ion implantation peeling.

In the step shown in Fig. 5A, an insulating layer (SiO₂ layer) is formed on the surface of a single-crystal silicon substrate 500.

In the step shown in Fig. 5B, hydrogen ions are implanted into the single-crystal silicon substrate 500, and the structure is annealed to form an ion-implanted layer (micro-cavity layer) inside the single-crystal silicon substrate 500. The acceleration energy of ions to be implanted is set such that the projection range has a desired depth. Although the size and density of formed micro cavities change depending on the implantation dose, the implantation dose is preferably about 1 × 10¹⁴ to 1 × 10¹⁵ cm⁻². To set a deep projection range, channeling ion implantation may be performed.

With this process, a first substrate having a single-crystal silicon layer (SOI active layer) 502 under an insulating layer 503 and the ion-implanted layer 501 under the single-crystal silicon layer 502 is formed. The first substrate has almost the same structure as that shown in Fig. 4C. When the ion-implanted layer 501 is observed with a transmission electron microscope, many micro cavities are found.

In Example 5, in a Class 1 clean room of the bay system using a 6N air filter, like Example 4 (Fig. 8), hydrogen ions are implanted using an ion implantation apparatus (not shown). The implantation dose was set to be 1 × 10¹⁵ cm⁻².

In Example 5, the gas pipeline of the ion implantation apparatus uses a CRP tube to remove metal impurities, thereby preventing the metal impurities from mixing in ion implantation.

In the step shown in Fig. 5C, the first substrate and a support substrate, i.e., a second substrate 510 are prepared and cleaned by an automatic wafer cleaning line.

In the step shown in Fig. 5D, the cleaned substrates are conveyed from the automatic wafer cleaning line to an automatic bonding apparatus and bonded by the automatic bonding apparatus.

A SOI substrate may be obtained only by polishing and selective etching, as in Example 4. However, in Example 5, after the bonded substrate stack was separated at the ion-implanted layer 501, the ion-implanted layer remaining on the support substrate side was polished, thereby obtaining an SOI substrate as shown in Fig. 5E.

When a bonded substrate stack is manufactured in a clean room with low cleanliness, particles or metal impurities attach to the single-crystal silicon substrate in which ions are to be implanted, and no ions are implanted to that portion. In this case, since a uniform ion-implanted layer 501 cannot be formed on the entire surface, the etching selectivity is lost, and a uniform SOI active layer 502 is difficult to obtain. Even in the process of separating the bonded substrate stack at the ion-implanted layer 501, separation is difficult at a portion where the ion-implanted layer 501 is not uniform, and the substrates may break.

On the other hand, when this process was performed in the clean room of Example 5, a uniform ion-implanted layer 501 could be formed on the entire surface. For this reason, the bonded substrate stack could be satisfactorily separated at the ion-implanted layer 501, and a uniform SOI active layer could be obtained.

As in Example 5, when the clean room using PTFE air filters was constructed in the downflow bay system, and the ionizer was set on the ceiling to prevent charge buildup in various substances such as wafers and wafer carriers in the clean room, any particles/foreign substances on the bonding interface could be decreased, and the HF void density could be largely lowered.

The present invention can be applied to another bonded SOI substrate manufacturing method. Examples of another bonded SOI substrate manufacturing method are as follows.

For example, after a first substrate is bonded to a second substrate via an insulating layer such as an oxide film, the lower surface of the first substrate is ground and polished to thin the substrate to about 1 to 3 µm, and the etching region for local plasma etching is scanned while monitoring the film thickness distribution, thereby forming an SOI layer.

Alternatively, a p⁺-type Si thin film which contains boron at a high concentration and a p-type Si thin film are formed on a p-type substrate by, e.g., epitaxial growth to prepare a first substrate. After the first substrate is bonded to a second substrate via an insulating layer such as an oxide film, the lower surface of the first substrate is ground and polished. After this, the remaining p-type Si thin film is selectively etched to expose the p⁺-type Si thin film, and the p⁺-type Si thin film is selectively etched to expose the p-type Si thin film, thereby completing an SOI structure.

In these manufacturing methods as well, when SOI substrates are manufactured in a Class 1 clean room of the bay system in which PTFE air filters and chemical filters are locally set, as in Example 5, the same effect as described above can be expected.

When a transparent insulating substrate such as a silica substrate is used as the support substrate, a transparent insulating substrate having a single-crystal silicon layer on the surface can be manufactured.

### (Effect of Second Embodiment)

According to this embodiment, when a clean room with cleanliness of Class 1 or more in the Fed. St. 209D: USA IS standard is constructed using an air filter having a collection efficiency of 99.99999% (7N) or more for dust particles of a size of 0.1µm or more, and a bonded SOI substrate is manufactured while exposing the bonding interface to only clean air, dust particles/foreign substances can be prevented from sticking to the bonding interface, and a high-quality bonded SOI substrate can be manufactured.

More specifically, according to this embodiment, a clean room with cleanliness of Class 1 or more in the Fed. St. 209D: USA IS standard is constructed using, as an air filter having a collection efficiency of 99.99999% (7N) or more for dust particles of a size of 0.1µm or more, an air filter using a chemically stable PTFE (polytetrafluoroethylene) filter medium, and a bonded SOI substrate is manufactured while exposing the bonding interface to only clean air. With this arrangement, dust from the air filter or chemical impurities such as boron can be largely decreased. Consequently, a bonded SOI substrate with minimum change properties due to an acid such as hydrofluoric acid used for substrate cleaning or etching in the clean room can be manufactured.

In addition, when not only PTFE air filters but also chemical filters are locally set in an area from bonding interface formation to bonding, chemical impurities such as boron which may enter from the outside or generated in a small amount from human bodies, wall material, or floor covering material and float in air can be suppressed from sticking to the bonding interface, so a bonded SOI substrate having higher quality can be manufactured.

In addition, when charge buildup in substances in the clean room are prevented, dust particles/foreign substances can be further prevented from sticking to the bonding interface, and a higher-quality bonded SOI substrate can be manufactured.

According to the bonded SOI substrate manufacturing method of this embodiment, the concentration of boron present on the bonding interface can be decreased to, e.g., 1 × 10¹⁶ atoms/cm³ or less. The density of HF voids formed upon dipping the structure in a 49% concentrated HF solution for 15 min is, e.g., 0.5 pieces/cm² or less.

As described above, according to this embodiment, high-quality bonded SOI substrates can be manufactured at high yield, and the manufacturing cost can be largely reduced.

According to the present invention, a high-quality bonded SOI substrate can be manufactured.

The present invention is not limited to the above embodiments and various changes and modifications can be made within the spirit and scope of the present invention. Therefore, to apprise the public of the scope of the present invention, the following claims are made.

## Claims

1. An SOI substrate manufacturing method comprising a step of bonding two substrates, characterized in that
at least a step of exposing a bonding interface between said two substrates to be bonded is performed in an atmosphere having cleanliness of not less than Class 1 in Fed. St. 209D: USA IS standard.

2. The method according to claim 1, characterized in that the atmosphere having cleanliness of not less than Class 1 is obtained using an air filter having a collection efficiency of not less than 99.9999% for dust particles of a size of not less than 0.1-µm.

3. The method according to claim 1, characterized in that the atmosphere having cleanliness of not less than Class 1 is obtained using an air filter having a collection efficiency of not less than 99.99999% for dust particles of a size of not less than 0.1-µm.

4. The method according to claim 3, characterized in that said air filter comprises an air filter having a PTFE (polytetrafluoroethylene) filter medium.

5. An SOI substrate manufacturing method comprising a step of bonding two substrates, characterized in that
at least a step of exposing a bonding interface between said two substrates to be bonded is performed in clean air filtered by an air filter having a PTFE (polytetrafluoroethylene) filter medium.

6. The method according to claim 5, characterized in that at least the step of exposing a bonding interface between said two substrates to be bonded is performed in clean air filtered not only by said air filter but also by a chemical filter.

7. The method according to any one of claims 2 to 5, characterized in that at least the step of exposing a bonding interface between said two substrates to be bonded is performed in a clean air downflow through said air filter.

8. The method according to any one of claims 2 to 6, characterized in that said air filter is arranged, on an entire ceiling surface of a clean room, at least above an apparatus for performing the step of exposing the bonding interface between said two substrates to be bonded.

9. The method according to claim 8, characterized in that said air filter is arranged not only on the ceiling of the clean room but also in an apparatus for processing said substrates with the exposed bonding interface.

10. The method according to any one of claims 1 to 9, characterized in that charge buildup in substances in an area where the step of exposing the bonding interface between said two substrates to be bonded is performed is prevented.

11. The method according to any one of claims 1 to 10, characterized in that a gas pipeline coupled to an apparatus for forming or processing a bonding interface wholly or partially comprises a CRP pipe.

12. The method according to any one of claims 2 to 6, characterized in that
at least the step of exposing a bonding interface between said two substrates to be bonded is performed in an environment where cleanliness is ensured by a local clean room system, and
said air filter is arranged in each of apparatuses for performing the step of exposing the bonding interface in the local clean room system and a conveyance apparatus between said apparatuses.

13. The method according to any one of claims 1 to 12, characterized in that an automatic apparatus which requires no manual operation in bonding is used as an apparatus for bonding said two substrates.

14. An SOI substrate manufacturing method comprising a step of bonding two substrates, characterized in that
an SOI substrate is manufactured in an environment where dust which may stick to a bonding interface between said two substrates is eliminated to obtain a void density of not more than 0.5 pieces/cm² after said manufactured SOI substrate is dipped in a 49% concentrated HF solution for 15 min.

15. An SOI substrate manufacturing method comprising a step of bonding two substrates, characterized in that
an SOI substrate is manufactured in an environment where chemical impurities which may contaminate a bonding interface between said two substrates is eliminated to obtain a boron concentration of not more than 1 × 10¹⁶ atoms/cm³ on the bonding interface of said manufactured SOI substrate.

16. The method according to any one of claims 1 to 15, characterized by comprising the steps of:
forming a porous layer on a substrate and forming a non-porous layer containing a single-crystal layer on said porous layer to prepare a first substrate;
bonding said first substrate to an independently prepared second substrate while sandwiching said non-porous layer therebetween;
removing said first substrate side from a bonded substrate stack to leave said porous layer on a surface on said second substrate side; and
etching said porous layer left on the surface on said second substrate side.

17. The method according to any one of claims 1 to 15, characterized by comprising the steps of:
implanting ions into a first substrate to form a micro-cavity layer;
bonding said first substrate having said micro-cavity layer to an independently prepared second substrate;
separating a bonded substrate stack at said micro-cavity layer; and
removing said micro-cavity layer left on a surface on said first substrate side.

18. The method according to any one of claims 1 to 15, characterized by comprising the steps of:
forming an oxide film on a first substrate;
bonding said first substrate having said oxide film to an independently prepared second substrate while sandwiching said oxide film therebetween; and
grinding said first substrate side of a bonded substrate stack and thinning said bonded substrate stack.

19. An SOI substrate manufactured by a manufacturing method comprising a step of bonding two substrates, characterized in that
a void density obtained when said SOI substrate is dipped in a 49% concentrated HF solution for 15 min is not more than 0.5 pieces/cm².

20. A group of SOI substrates manufactured by a manufacturing method comprising a step of bonding two substrates, characterized in that
an average void density obtained when said SOI substrates are dipped in a 49% concentrated HF solution for 15 min is not more than 0.5 pieces/cm².

21. An SOI substrate manufactured by a manufacturing method comprising a step of bonding two substrates, characterized in that
a concentration of boron on a bonding interface is not more than 1 × 10¹⁶ atoms/cm³.

22. A group of SOI substrates manufactured by a manufacturing method comprising a step of bonding two substrates, characterized in that
an average concentration of boron on a bonding interface is not more than 1 × 10¹⁶ atoms/cm³.

23. A manufacturing system for performing the SOI substrate manufacturing method of any one of claims 1 to 19.

24. A method of producing a semiconductor integrated circuit performed by manufacturing an SOI substrate having an epitaxial silicon layer by any method of claims 1 to 18, and producing an integrated circuit using said epitaxial silicon layer as active layer.
